# FASCICULE DE BREVET EUROPEEN

(11) **EP 2 865 017 B1**
(45) Date de publication et mention de la délivrance du brevet: **13.11.2019**
(21) Numéro de dépôt: 13729748.7
(22) Date de dépôt: 19.06.2013
(51) Int. Cl.: H01L 31/109, H01L 31/0232, H01L 31/103

(54) **STRUCTURE SEMICONDUCTRICE COMPORTANT UNE ZONE ABSORBANTE PLACÉE DANS UNE CAVITÉ FOCALISANTE**
HALBLEITERSTRUKTUR MIT ABSORBIERENDEM BEREICH IN EINEM FOKUSIERENDEN RESONATOR
SEMICONDUCTOR STRUCTURE WITH ABSORBING REGION IN A FOCUSING CAVITY

(30) Priorité: 20.06.2012 FR 1255786
(43) Date de publication de la demande: 29.04.2015
(73) Titulaire: Commissariat à l'Énergie Atomique et aux Énergies Alternatives, 75015 Paris (FR)
(72) Inventeur: BOULARD, François, 38000 Grenoble (FR); ESPIAU DE LAMAESTRE, Roch, 38000 Grenoble (FR); FOWLER, David, 38950 Saint Martin Le Vinoux (FR); GRAVRAND, Olivier, 38120 Fontanil Cornillon (FR); ROTHMAN, Johan, 38000 Grenoble (FR)
(74) Mandataire: Brevalex
(86) Numéro de dépôt international: PCT/EP2013/062771
(87) Numéro de publication internationale: WO 2013/189997

(56) Documents cités:
- EP-A1- 2 276 072
- US-A- 5 952 703
- US-B1- 6 803 557
- US-B1- 7 459 730
- D. STANASZEK, J. PIOTROWSKI, A. PIOTROWSKI, W. GAWRON, Z. ORMAN, R. PALIWODA, M. BRUDNOWSKI, J. PAWLUCZYK AND M. PEDZINSKA: "Mid and long infrared detection modules for picosecond range measurements", SPIE, CONFERENCE PROCEEDINGS, ELECTRO-OPTICAL REMOTE SENSING, PHOTONIC TECHNOLOGIES AND APPLICATIONS III, BERLIN, vol. 7482, 1 septembre 2009 (2009-09-01), - 3 septembre 2009 (2009-09-03), pages 74820M-1-7482M-11, XP040502300, Bellingham, USA
- PIOTROWSKI J ET AL: "Uncooled long wavelength infrared photon detectors", INFRARED PHYSICS AND TECHNOLOGY, ELSEVIER SCIENCE, GB, vol. 46, no. 1-2, 1 décembre 2004 (2004-12-01), pages 115-131, XP025960146, ISSN: 1350-4495, DOI: 10.1016/J.INFRARED.2004.03.016 [extrait le 2004-10-28]

## Description

### DOMAINE TECHNIQUE

L'invention se rapporte au domaine de la détection et/ou de la mesure de rayonnements électromagnétiques et aux dispositifs permettant une telle détection et/ou mesure.

L'évolution rapide de l'optoélectronique, liée à l'adaptation des technologies de la micro-électronique aux semiconducteurs à gap direct, a permis une amélioration des performances de détection et/ou de mesure des dispositifs permettant la détection et/ou la mesure de rayonnements électromagnétiques quelle que soit leur gamme de longueurs d'ondes.

Ces dispositifs mettent généralement en œuvre des structures semiconductrices aptes à recevoir un rayonnement électromagnétique et à le transformer en un signal électrique.

L'invention se rapporte plus particulièrement à une structure semiconductrice, à un composant semiconducteur et à un procédé de fabrication d'une telle structure semiconductrice.

### ÉTAT DE LA TECHNIQUE ANTÉRIEURE

Les structures semiconductrices adaptées pour recevoir un rayonnement électromagnétique comprennent généralement une première et une seconde zone semiconductrice en contact l'une de l'autre et présentant respectivement un premier et un second type de conductivité opposés l'un de l'autre. De cette manière la première et la seconde zone forment ensemble, au niveau de leur contact, une jonction semiconductrice.

Ainsi, pour un support dont le matériau semiconducteur est un matériau semiconducteur à gap direct et pour une polarisation inverse de la jonction, lorsqu'un photon, ayant une énergie supérieure à celle de la bande interdite du matériau semiconducteur, pénètre la jonction semiconductrice, celui-ci va générer une paire électron-trou qui, en raison du champ électrique régnant dans la structure, diffuse dans la structure de manière à former un courant photogénéré. Ce courant, étant directement proportionnel au rayonnement électromagnétique, fournit une mesure de ce même rayonnement électromagnétique.

On entend par matériau semiconducteur à gap direct un matériau semiconducteur dont le maximum d'énergie de la bande de valence et le minimum d'énergie de la bande de conduction se situent à une valeur du vecteur d'onde k sensiblement égale dans le diagramme de dispersion énergétique dudit matériau semiconducteur.

Si une telle technologie est bien adaptée pour la détection et la mesure de rayonnements électromagnétiques, elle possède néanmoins l'inconvénient de présenter un courant d'obscurité non nul, ce qui participe à dégrader le rapport signal sur bruit. Le courant d'obscurité a pour origine la génération de paires électron-trou non photo-générées dans la structure. Or cette génération a principalement lieu dans la zone active de la structure dans laquelle les photons sont absorbés pour générer le signal. Cette zone, pour maximiser le signal, doit occuper une grande partie du volume de la structure, celle-ci s'étendant généralement sur la quasi-totalité de la surface de la structure, et est donc à l'origine d'un bruit important.

Ceci est d'autant plus vrai pour les structures adaptées pour fonctionner dans les longueurs d'onde infrarouge, ces dernières étant sujettes à un bruit important en raison de la faible largeur de bande interdite du matériau dans lequel elles sont formées. En effet, une faible largeur de bande interdite favorise la formation d'un courant d'obscurité tunnel dans la zone active.

Pour remédier à cet inconvénient, il est connu de concentrer le rayonnement électromagnétique dans une zone réduite de la structure dans laquelle est ménagée la jonction et donc la zone active. Ainsi, la structure peut recevoir le rayonnement électromagnétique sur une surface importante sans pour autant nécessiter une zone active occupant un volume important.

Une telle concentration du rayonnement électromagnétique peut être notamment obtenue, comme cela est décrit dans le document EP 2276072, aux moyens d'un concentrateur de type Fabry-Pérot qui permet de concentrer le rayonnement électromagnétique dans une zone réduite de la structure dans laquelle peut être ménagée la jonction.

Si le document EP 2276072 ne précise pas de configuration structurelle, il est néanmoins nécessaire, pour qu'une telle structure soit fonctionnelle, que la jonction soit aménagée dans la couche semiconductrice au niveau de laquelle le concentrateur de type Fabry-Pérot concentre le rayonnement électromagnétique. Il en résulte que, pour une structure adaptée pour recevoir un rayonnement électromagnétique dont la longueur d'onde est λ₀, l'épaisseur de la structure sur laquelle est capturé le rayonnement électromagnétique est limitée par la couche semiconductrice dans laquelle est aménagée la jonction. Cette couche devant présenter une épaisseur comprise entre λ₀/4nₑ et λ₀/10nₑ, l'épaisseur de la zone active de la jonction sur laquelle est absorbée le rayonnement électromagnétique est donc réduite et une partie du rayonnement électromagnétique peut, en raison de cette faible épaisseur traverser la structure sans être absorbée.

Il en résulte que si une telle structure présente, par rapport à une simple diode inversée, une réduction du courant d'obscurité, cette réduction est également accompagnée par une réduction du taux d'absorption du rayonnement électromagnétique. Le gain en rapport signal sur bruit apporté par cette solution, par rapport à une simple diode inversée, est donc réduit en raison de la faible épaisseur de la zone active sur laquelle le rayonnement électromagnétique est absorbé.

### EXPOSÉ DE L'INVENTION

La présente invention vise à remédier à cet inconvénient.

Un but de l'invention est de fournir une structure semiconductrice qui présente un rapport signal sur bruit optimisé par rapport aux structures de l'art antérieur.

A cet effet l'invention se rapporte à une structure semiconductrice telle que définie dans la revendication 1. Cette structure est destinée à recevoir un rayonnement électromagnétique dans une première gamme de longueurs d'onde, dite de fonctionnement, qui est centrée autour d'une longueur d'onde λ₀, et comporte :
- une première zone semiconductrice d'un premier type de conductivité,
- une deuxième zone semiconductrice d'un deuxième type de conductivité opposé au premier type de conductivité, la deuxième zone semiconductrice étant en contact avec la première zone semiconductrice de manière à former une jonction semiconductrice,
la deuxième zone semiconductrice présentant une portion dont la concentration en porteurs majoritaires est au moins inférieure de dix fois à la concentration en porteurs majoritaires de la première zone semiconductrice, ladite portion étant en contact avec la première zone semiconductrice,
ladite portion de la deuxième zone semiconductrice étant essentiellement ménagée dans une première cavité adaptée pour focaliser dans la première cavité une partie du champ électromagnétique reçu.

L'aménagement de la deuxième zone semiconductrice dans une première cavité adaptée pour concentrer le champ électromagnétique et le fait que la portion de la deuxième zone semiconductrice présente une concentration en porteurs majoritaires réduite par rapport à la première zone semiconductrice, permettent à la structure de présenter sa zone active, formée par la zone de charge d'espace de la jonction, principalement comprise dans la cavité. En effet, la deuxième zone semiconductrice présentant une portion avec une concentration en porteurs majoritaires réduite, la zone de charge d'espace, correspondant à la zone active, s'étend principalement dans cette portion.

De plus, la relativement faible concentration en porteurs majoritaires de la portion de deuxième zone semiconductrice induit une déplétion des porteurs majoritaires dans cette même portion de la deuxième zone semiconductrice, limitant ainsi les risques de recombinaisons paires électron-trou qui est la source du courant d'obscurité. On peut enfin noter qu'une telle configuration de la structure, par la courbure de bande induite le long de la portion de la deuxième zone semiconductrice permet une collection des porteurs minoritaires photogénérés par écoulement de ces derniers le long de la portion et non par diffusion. Le temps de collection s'en trouve réduit, par rapport à une structure collectant le courant photogénéré par diffusion de porteurs. La réponse de la structure est donc fiabilisée vis-à-vis des structures de l'art antérieur qui présentent une probabilité plus importante de recombinaison des paires électron-trou photogénérées avant leur collection. Il en résulte qu'une structure selon l'invention permet un étalonnage reproductible avec une sensibilité accrue vis-à-vis d'une structure selon l'art antérieur.

Une cavité comprise dans un composant optoélectronique peut être une cavité résonante ou optique, telle qu'une cavité du type Fabry-Pérot. Ainsi une telle cavité n'est donc pas forcément vide puisque pouvant contenir, par exemple, un milieu actif comme c'est le cas pour un composant du type laser semiconducteur.

Par focalisation on entend, dans le domaine de l'optique et de l'optoélectronique, le fait de faire converger un faisceau lumineux de manière à le concentrer dans un faible volume.

Par ailleurs, il est possible, à niveau signal sur bruit équivalent, d'augmenter la température de fonctionnement du dispositif.

Par portion essentiellement ménagée dans la cavité, on entend que la portion est au moins en partie disposée dans la cavité, la portion de la deuxième zone semiconductrice présentant plus de la moitié de son volume ménagée dans la première cavité.

La portion de la deuxième zone semiconductrice représente la majeure partie de la deuxième zone semiconductrice qui est ménagée dans la première cavité.

La première cavité est une cavité du type Fabry-Pérot particulièrement adaptée pour permettre une concentration d'un champ électromagnétique.

La première cavité présente selon au moins une direction de confinement une dimension moyenne sensiblement égale à λ₀/2n_{eff} avec n_{eff} l'indice effectif moyen dans la deuxième zone semiconductrice.

Une cavité Fabry-Pérot dont la dimension moyenne est sensiblement égale à λ₀/2n_{eff} est particulièrement adaptée pour concentrer un rayonnement électromagnétique dont la longueur d'onde est comprise dans la gamme de fonctionnement.

La structure étant destinée à recevoir le rayonnement électromagnétique selon une direction moyenne de réception, la direction de confinement peut être sensiblement perpendiculaire à la direction moyenne de réception.

Une telle orientation de la dimension de confinement permet d'obtenir un confinement de la structure selon une direction perpendiculaire de la jonction autorisant le dimensionnement au besoin de l'épaisseur selon laquelle s'étend la portion, limitant ainsi la partie du rayonnement électromagnétique qui ne serait pas absorbée lors de son passage dans la structure.

On peut également noter que dans la configuration dans laquelle la jonction s'étend sensiblement dans le plan de la surface de la structure, une telle direction de la dimension de la cavité permet une focalisation de la composante transverse électrique (TE) du champ électromagnétique.

La dimension de la première cavité selon la direction de confinement est une dimension variable, ladite dimension diminuant préférentiellement de la première zone semiconductrice vers la deuxième zone semiconductrice.

Une telle dimension variable permet d'élargir la gamme de longueurs d'onde du rayonnement électromagnétique qui est focalisé dans la première cavité.

La dimension de la première cavité selon la direction de confinement varie sensiblement monotonement selon la direction allant de la première zone semiconductrice vers la deuxième zone semiconductrice.

La dimension de la première cavité selon la direction de confinement varie selon un angle compris entre 0 et 40° par rapport à la direction allant de la première zone semiconductrice vers la deuxième zone semiconductrice.

La jonction peut être une hétérojonction.

Un tel type de jonction permet d'adapter la largeur de bande interdite de chaque zone semiconductrice et peut permettre d'optimiser la partie du rayonnement électromagnétique absorbée par la zone semiconductrice fonctionnelle de la jonction.

La première et la deuxième zone semiconductrice peuvent présenter des largeurs de bande interdite d'énergies différentes, la deuxième zone semiconductrice peut présenter une largeur de bande interdite moyenne d'énergie supérieure à celle d'un rayonnement dont la longueur d'onde est comprise dans la gamme de fonctionnement.

On entend ci-dessus et dans le reste de ce document par énergie correspondant à la largeur de bande interdite, la différence d'énergie entre le minimum d'énergie de la bande de conduction et le maximum d'énergie de la bande de valence ceci à la température à laquelle est destinée à fonctionner la structure semiconductrice.

Ainsi le rayonnement électromagnétique, dans une configuration dans laquelle le rayonnement électromagnétique traverse la première zone semiconductrice avant d'arriver dans la deuxième zone semiconductrice, présente une atténuation réduite lors de son passage au travers de la première zone semiconductrice.

La première et la deuxième zone semiconductrice peuvent présenter des largeurs de bande interdite d'énergies différentes, la première zone semiconductrice présentant une largeur de bande interdite moyenne d'énergie inférieure à celle d'un rayonnement dont la longueur d'onde est comprise dans la gamme de fonctionnement.

Ainsi la deuxième zone semiconductrice est particulièrement adaptée pour l'absorption du rayonnement électromagnétique.

la deuxième zone semiconductrice comporte, outre ladite portion, une partie non ménagée dans la cavité et présentant une largeur de bande interdite moyenne d'énergie supérieure à celle d'un rayonnement électromagnétique dont la longueur d'onde est comprise dans la gamme de fonctionnement, et ladite portion présentant une largeur de bande interdite moyenne d'énergie inférieure à celle d'un rayonnement électromagnétique dont la longueur d'onde est comprise dans la première gamme de fonctionnement.

Avec une telle configuration de la deuxième zone semiconductrice, l'absorption de rayonnement à lieu uniquement dans la cavité.

La première zone semiconductrice peut présenter une largeur de bande interdite qui diminue en direction de la deuxième zone semiconductrice.

Le rayonnement électromagnétique est reçu dans un milieu d'indice optique nᵢ, dit indice incident, le rapport entre l'indice effectif et l'indice incident n_{eff}/nᵢ étant supérieur à 1, préférentiellement sensiblement supérieur à 1,5, et encore plus préférentiellement supérieur à 2.

Avec une réception du rayonnement dans un milieu d'indice optique nᵢ, un tel rapport entre l'indice effectif n_{eff} et l'indice incident nᵢ permet de fournir une bonne focalisation du rayonnement électromagnétique dans la cavité.

On entend ci-dessus et dans le reste de ce document, par indice optique d'un milieu, l'indice de réfraction du milieu pour la première gamme de longueurs d'onde.

Le milieu d'indice incident nᵢ peut être un support de la structure.

Le milieu d'indice incident nᵢ peut être une zone d'air au travers de laquelle le rayonnement est reçu par la structure.

Les première et deuxième zones semiconductrices peuvent être réalisées dans des matériaux semiconducteurs composés essentiellement d'au moins trois mêmes éléments dont la concentration en au moins l'un de ces éléments permet de faire varier la largeur de bande interdite, lesdits éléments étant préférentiellement le cadmium (Cd), le mercure (Hg) et le tellure (Te).

De tels éléments autorisent, par une variation de la concentration d'au moins un de ces éléments, la modification de la largeur de bande interdite le long de la structure donnant accès ainsi à la possibilité d'optimiser cette largeur de bande interdite selon les zones semiconductrices de la structure et de leur fonction.

En effet les tellurures de mercure-cadmium possèdent entre autres avantages de présenter une largeur de bande interdite qui varie avec la concentration en cadmium ceci sans que cela n'affecte leur propriété de semiconducteur à gap direct. Ainsi, il est possible en faisant varier les proportions en éléments que sont le tellure (Te), le cadmium (Cd) et le mercure (Hg) de former une hétérojonction avec une largeur de bande interdite de chacune des zones semiconductrices de la jonction qui est adaptée en fonction des besoins.

La gamme de fonctionnement peut être comprise dans la gamme de longueurs d'onde des infrarouges.

Il peut être prévu :
- un support transparent dans la gamme de fonctionnement, le substrat comportant une première et une seconde face,
- une première couche semiconductrice du premier type de conductivité s'étendant le long de la première face en contact avec cette même première face, une portion de ladite première couche semiconductrice formant la première zone semiconductrice,
- un mesa semiconducteur en contact direct, ou par l'intermédiaire d'une deuxième couche semiconductrice du deuxième type de conductivité, avec la face de la première couche semiconductrice qui est opposée à la première face, ledit mesa présentant le deuxième type de conductivité et sur une partie du mesa une concentration en porteurs majoritaires qui est au moins dix fois inférieure à celle de la première couche semiconductrice, ledit mesa formant au moins partiellement la deuxième zone semiconductrice, le mesa présentant au moins une direction, la direction de confinement, selon laquelle le mesa présente une dimension moyenne de λ₀/2n_{eff}, la partie du mesa formant au moins partiellement la portion de la deuxième zone semiconductrice,
- une zone, dite réfléchissante, réalisée dans un matériau au moins partiellement réfléchissant dans la gamme fonctionnement, la zone réfléchissante recouvrant au moins une partie du mesa de manière à former la première cavité de type Fabry-Pérot qui présente une dimension moyenne sensiblement égale à λ₀/2n_{eff} selon la direction de confinement.

Une telle structure est particulièrement adaptée aux contraintes de fabrication de l'opto-électronique.

Il peut être prévu une deuxième couche semiconductrice en contact avec la surface de la première face qui est opposée à la première face, le mesa étant en contact direct avec la deuxième couche semiconductrice et en contact avec la première couche semiconductrice au travers de la deuxième couche semiconductrice, la deuxième couche présentant au moins une partie dont la concentration en porteurs majoritaires est dix fois inférieure à celle de première couche semiconductrice, la deuxième couche semiconductrice et le mesa formant la deuxième zone semiconductrice et les parties respectifs du mesa et de la deuxième couche semiconductrice formant la portion de la deuxième zone semiconductrice.

Le mesa peut être en contact direct avec la première couche semiconductrice.

Il peut être en outre prévu au moins une troisième et une quatrième zone semiconductrice présentant respectivement le premier et le deuxième type de conductivité, la troisième et la quatrième zone semiconductrice étant en contact l'une avec l'autre de manière à former une jonction semiconductrice, la quatrième zone semiconductrice présente une deuxième portion dont la concentration en porteurs majoritaires est au moins inférieure de dix fois la concentration en porteurs majoritaires de la troisième zone semiconductrice, ladite deuxième portion étant la portion de la quatrième zone semiconductrice qui est en contact avec la troisième zone semiconductrice, la quatrième zone semiconductrice est essentiellement ménagée dans une deuxième cavité, ladite deuxième cavité étant adaptée pour concentrer dans la deuxième cavité une partie du rayonnement électromagnétique qui est reçu par la structure et dont la longueur d'onde est comprise dans une gamme de longueurs d'onde dite deuxième gamme de fonctionnement.

De telles troisième et quatrième zones semiconductrices et la deuxième cavité qui leur est associée, permettent d'augmenter la surface de la structure sur laquelle le rayonnement électromagnétique est collecté et donc le signal fourni par la structure lorsque cette dernière reçoit un rayonnement électromagnétique.

Elles permettent également, pour une deuxième gamme de fonctionnement différente de la première gamme de fonctionnement de fournir une structure adaptée pour recevoir un rayonnement électromagnétique à la fois dans la première gamme de fonctionnement et dans la deuxième gamme de fonctionnement.

La deuxième gamme de fonctionnement est sensiblement identique à la première gamme de fonctionnement.

Ainsi, la structure présente, pour les rayonnements électromagnétiques dont la longueur d'onde est comprise dans la première gamme de fonctionnement, une surface de réception de ces rayonnements électromagnétiques qui est augmentée par rapport à une structure ne comportant pas une deuxième cavité adaptée pour focaliser dans la deuxième cavité une partie du rayonnement électromagnétique qui est reçue par la structure et dont la longueur d'onde est comprise dans la première gamme de fonctionnement.

La deuxième gamme de fonctionnement peut être différente de la première gamme de fonctionnement, la première et la deuxième gamme de fonctionnement étant préférentiellement choisies pour couvrir une gamme de longueurs d'onde continue.

Ainsi, la structure est adaptée pour la réception de rayonnements électromagnétiques sur une gamme de longueurs d'onde de plus grande largeur qu'une structure ne comportant pas de deuxième cavité.

L'invention concerne également un composant semiconducteur comportant une pluralité de structures semiconductrices destinées à recevoir un rayonnement électromagnétique, au moins l'une des structures étant une structure selon l'invention.

Un tel composant, présente, pour la ou les structures selon l'invention, un rapport signal sur bruit optimisé vis-à-vis d'un composant comportant uniquement des structures selon l'art antérieur.

L'invention concerne également un procédé de fabrication d'une structure destinée à recevoir un rayonnement électromagnétique dans une première gamme de longueurs d'onde, dite de fonctionnement, qui est centrée autour d'une longueur d'onde λ₀, le procédé comportant les étapes consistant à :
- Fournir un support présentant une première et une seconde face,
- Former une première couche semiconductrice d'un premier type de conductivité, au moins une portion de ladite couche semiconductrice formant une première zone semiconductrice,
- Former un mesa semiconducteur en contact avec la couche semiconductrice, ledit mesa étant d'un deuxième type de conductivité opposé au premier type de conductivité et comportant une portion, en contact avec la première couche semiconductrice, dont la concentration en porteurs majoritaires est au moins inférieure de dix fois la concentration en porteurs majoritaires de la première couche semiconductrice, le mesa présentant au moins une direction, dite de confinement, selon laquelle le mesa présente une dimension moyenne de λ₀/2n_{eff}, le mesa formant avec au moins partiellement une deuxième zone semiconductrice,
- déposer une couche d'un matériau au moins partiellement réfléchissant dans la gamme de fonctionnement de manière à former une zone dite réfléchissante, la zone réfléchissante recouvrant au moins une partie du mesa de manière à former une première cavité de type Fabry-Pérot qui présente une dimension moyenne sensiblement égale à λ₀/2n_{eff} selon la direction de confinement.

Un tel procédé permet la formation d'une structure présentant dans la gamme de fonctionnement un rapport signal sur bruit amélioré vis-à-vis d'une structure de l'art antérieur.

Le procédé de fabrication peut comporter entre l'étape de formation de la première couche semiconductrice et l'étape de formation du mesa, une étape de formation d'une deuxième couche semiconductrice du deuxième type de conductivité en contact avec la première couche semiconductrice sur la face de la première couche semiconductrice qui est opposée au support, le mesa étant formé en contact avec la deuxième couche semiconductrice.

Alternativement le procédé de fabrication d'une structure destinée à recevoir un rayonnement électromagnétique dans une première gamme de longueurs d'onde, dite de fonctionnement, qui est centrée autour d'une longueur d'onde λ₀, peut comporter les étapes consistant à :
- fournir un support présentant une première et une seconde face,
- former une première couche semiconductrice d'un premier type de conductivité, au moins une portion de ladite première couche semiconductrice formant une première zone semiconductrice,
- former une deuxième couche semiconductrice en contact avec la première couche semiconductrice, ladite deuxième couche semiconductrice étant d'un deuxième type de conductivité qui est opposé au premier type de conductivité, au moins une partie de la deuxième couche semiconductrice qui est en contact avec la première couche semiconductrice présentant une concentration en porteurs majoritaires qui est au moins inférieure de dix fois la concentration en porteurs majoritaires de la première couche semiconductrice,
- former un mesa semiconducteur en contact avec la partie de la deuxième couche semiconductrice, ledit mesa étant du deuxième type de conductivité et comportant au moins une partie, en contact avec la partie de la deuxième couche semiconductrice, dont la concentration en porteurs majoritaires est au moins inférieure de dix fois la concentration en porteurs majoritaires de la première couche semiconductrice, le mesa présentant au moins une direction, dite de confinement, selon laquelle le mesa présente une dimension moyenne de λ₀/2n_{eff}, le mesa formant avec la deuxième couche semiconductrice au moins partiellement une deuxième zone semiconductrice et la partie du mesa formant avec la partie de la deuxième couche semiconductrice une portion de la deuxième zone,
- déposer une couche d'un matériau au moins partiellement réfléchissant dans la gamme de fonctionnement, ladite couche recouvrant au moins une partie du mesa de manière à former une première cavité de type Fabry-Pérot qui présente une dimension moyenne sensiblement égale à λ₀/2n_{eff} selon la direction de confinement.

Il peut être prévu avant l'étape de formation de la deuxième couche semiconductrice une étape de formation d'une troisième couche semiconductrice du premier type de conductivité en contact avec la première couche semiconductrice, la première couche et la troisième couche semiconductrice comportant une concentration en impuretés du type donneur de porteurs majoritaires du deuxième type de conductivité qui est au moins dix fois inférieure à la concentration en porteurs majoritaires desdites première et troisième couches semiconductrice, les étapes de formation du mesa et de la deuxième couche semiconductrice étant obtenues par gravure de la troisième couche conductrice et une partie de la première couche conductrice, cette étape de gravure étant adaptée pour inhiber les porteurs majoritaires du premier type de conductivité.

### BRÈVE DESCRIPTION DES DESSINS

La présente invention sera mieux comprise à la lecture de la description d'exemples de réalisation, donnés à titre purement indicatif et nullement limitatif, en faisant référence aux dessins annexés sur lesquels :
- la figure 1 illustre une vue en coupe d'un exemple de structure selon un premier mode de réalisation de l'invention,
- la figure 2 illustre la répartition en Cadmium le long de la structure illustrée sur la figure 1,
- la figure 3 illustre un exemple de configuration d'une structure selon le premier mode de réalisation de l'invention,
- les figures 4a à 4n illustrent les étapes d'un procédé de fabrication d'une structure telle qu'illustrée sur la figure 1,
- la figure 5 illustre un exemple de structure de bande le long d'une structure selon le premier mode de réalisation de l'invention,
- la figure 6 illustre un composant comportant plusieurs structures selon l'invention,
- les figures 7a à 7f illustrent des exemples de configuration de structures selon différentes possibilités de l'invention,
- la figure 8 illustre une coupe d'une structure selon une possibilité de l'invention dans laquelle la structure comporte plusieurs cavités,
- les figures 9a à 9d illustrent différentes étapes de fabrication d'une structure selon un deuxième mode de réalisation de l'invention.

Des parties identiques, similaires ou équivalentes des différentes figures portent les mêmes références numériques de façon à faciliter le passage d'une figure à l'autre.

Les différentes parties représentées sur les figures ne le sont pas nécessairement selon une échelle uniforme, pour rendre les figures plus lisibles.

Les différentes possibilités (variantes et modes de réalisation) doivent être comprises comme n'étant pas exclusives les unes des autres et peuvent se combiner entre elles.

### EXPOSÉ DÉTAILLÉ DE MODES DE RÉALISATION PARTICULIERS

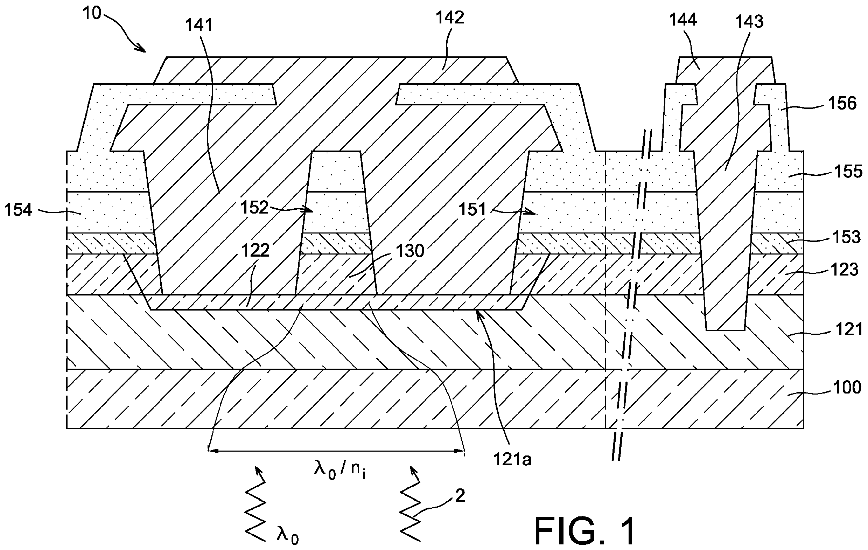

La figure 1 illustre une structure 10 semiconductrice, destinée à recevoir un rayonnement électromagnétique 2 dans une première gamme de longueurs d'onde, selon un premier mode de réalisation de l'invention. La première gamme de longueurs d'onde, qui est dite gamme de fonctionnement, est centrée autour d'une longueur d'onde λ₀.

La première gamme de fonctionnement est une gamme de longueurs d'onde qui peut être comprise aussi bien dans la gamme de longueurs d'onde du visible, des ultraviolets ou encore des infrarouges. Dans l'application particulière illustrée sur la figure 1, la gamme de longueurs d'onde est comprise dans les infrarouges et peut être, selon les besoins, une gamme de longueurs d'onde du proche infrarouge, de l'infrarouge moyen ou de l'infrarouge lointain.

Les caractéristiques et les valeurs qui sont mentionnées dans le reste de ce document, lorsqu'elles sont indiquées comme concernant l'application particulière, s'appliquent uniquement à cette application particulière et ne limitent donc en rien la portée de l'invention.

Une structure 10 selon ce premier mode de réalisation comporte :
- un support 100, éventuellement semiconducteur, transparent dans la gamme de fonctionnement, le support comportant une première et une seconde face,
- une première couche semiconductrice 121 du premier type de conductivité s'étendant le long de la première face du support en contact avec cette même première face,
- une deuxième couche semiconductrice 122 du deuxième type de conductivité s'étendant le long d'une région de la première couche en contact, dans ladite région, avec la face de la première couche qui est opposée à la première face du support,
- une troisième couche semiconductrice 123 en contact avec la première couche sur la face de première couche opposée au support, la troisième couche semiconductrice étant en contact sur la surface de ladite face qui n'est par recouverte par la deuxième couche semiconductrice,
- un mesa 130 semiconducteur en contact avec la deuxième couche semiconductrice 122 sur la surface de la deuxième couche semiconductrice 122 qui est opposée à la première couche semiconductrice 121, ledit mesa 130 présentant le deuxième type de conductivité,
- une zone 141, dite réfléchissante, réalisée dans un matériau conducteur qui est au moins partiellement réfléchissant dans la gamme de fonctionnement, ladite zone réfléchissante 141 en contact avec le mesa 130 sur les côtés du mesa 130 et avec la deuxième couche semiconductrice 122 sur sa face qui est opposée à la première couche semiconductrice 121 dans la partie de ladite face qui n'est pas en contact avec le mesa 130, ledit matériau étant un matériau conducteur électriquement, la zone réfléchissante 141 formant un premier contact électrique,
- une première et une seconde zone isolante 151, 152 dans un matériau isolant, la première zone isolante 151 étant en contact avec la troisième couche semiconductrice 123 et la deuxième zone isolante 152 avec le mesa 130,
- un deuxième contact électrique 143 en contact avec la première couche semiconductrice 121 au travers de la première zone isolante 151 et de la troisième couche semiconductrice 123.

Le support semiconducteur 100 est un support classiquement utilisé pour les applications optoélectroniques. Le support est préférentiellement un substrat transparent dans la première gamme de fonctionnement. Le support 100 est réalisé dans un matériau semiconducteur classiquement utilisé pour les applications de l'optoélectronique, tel que par exemple, le silicium, le carbure de silicium, le saphir. Le support présente un indice optique, ou indice de réfraction, nᵢ.

Dans l'application particulière de l'invention, le support 100 est un substrat en tellurure de zinc cadmium (CdZnTe) qui est transparent dans la gamme de longueurs d'onde de l'infrarouge. Ainsi, le rayonnement électromagnétique dont la longueur d'onde est comprise dans la gamme de fonctionnement est transmis au travers du support 100 sans y être absorbé. Le support est préférentiellement au moins partiellement isolant. Dans cette même application particulière, l'indice optique nᵢ du support est de 2,7.

Le support 100 est un support sensiblement plan dont une première face est en contact avec la première couche semiconductrice 121. La deuxième face du support 100 est la face de la structure qui, comme cela est illustré sur la figure 1, reçoit le rayonnement électromagnétique.

La première couche semiconductrice 121 est une couche semiconductrice adaptée pour les applications optoélectroniques. La première couche semiconductrice 121 est réalisée dans un matériau semiconducteur à gap direct tel que l'arséniure de gallium (GaAs) et le phosphure d'indium (InP). La première couche semiconductrice 121 présente le premier type de conductivité. Le premier type de conductivité est un type de conductivité sélectionné dans le groupe comportant le type de conductivité dont les porteurs majoritaires sont les électrons et le type de conductivité dont les porteurs majoritaires sont les trous.

La concentration en porteurs majoritaires de la première couche semiconductrice 121 est significativement importante. Elle présente ainsi une bonne conductivité. La première couche semiconductrice 121 peut présenter, par exemple, une concentration en porteurs majoritaires supérieure à 10¹⁷cm⁻³. La largeur de bande interdite de la première couche semiconductrice 121 est préférentiellement d'une énergie supérieure à celle d'un rayonnement électromagnétique dont la longueur d'onde est comprise dans la gamme de fonctionnement. La largeur de bande interdite de la première couche semiconductrice 121 peut être, le long de son épaisseur, variable ou constante. Dans le cas où la largeur de bande interdite de la première couche semiconductrice 121 est variable le long de son épaisseur, la première couche semiconductrice 121 présente une largeur de bande interdite qui diminue en direction de la deuxième couche semiconductrice 122. La diminution de la largeur interdite le long de l'épaisseur de la première couche semiconductrice 121 peut être continue ou par paliers.

Dans l'application particulière, la première couche semiconductrice 121 est une couche en tellurure de mercure-cadmium du type Cd_{X}Hg_{1-X}Te avec X la proportion en cadmium qui est comprise entre 0,2 et 1. La valeur minimale de la proportion en cadmium X est choisie en fonction de la gamme de fonctionnement de manière à ce que la première couche semiconductrice 121 présente une largeur de bande interdite dont l'énergie est supérieure à celle d'un rayonnement électromagnétique dont la longueur d'onde est comprise dans la gamme de fonctionnement.

Ainsi, pour des structures 10 adaptées pour recevoir un rayonnement électromagnétique dans la gamme des infrarouges moyens inférieurs à 3 µm, la proportion minimum en cadmium X peut être supérieure à 0,5, et pour la gamme des infrarouges moyens inférieurs à 5 µm, la proportion en cadmium X peut être supérieure à 0,4. Pour des structures 10 adaptées pour recevoir un rayonnement électromagnétique dans la gamme des infrarouges lointains inférieurs à 10 µm, la proportion minimun en cadmium X peut être supérieure à 0,3.

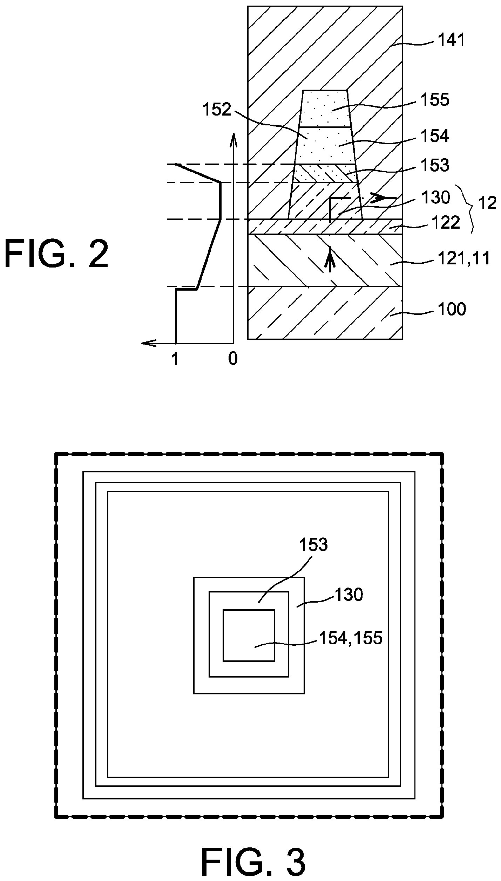

Dans l'application particulière, la largeur de bande interdite présente une variation continue le long de l'épaisseur de la première couche semiconductrice 121. Une telle variation est obtenue, comme l'illustre la figure 2, en variant la concentration en cadmium le long de l'épaisseur de la première couche semiconductrice 121 d'une valeur de 0,5 au niveau du support à une valeur, au niveau de la deuxième couche semiconductrice 122, supérieure à celle du mésa 130, par exemple 0,32.

Dans l'application particulière, le type de conductivité de la première couche semiconductrice 121 est un type de conductivité dont les porteurs majoritaires sont des trous. De même la concentration en porteurs majoritaires de la première couche semiconductrice 121 est comprise, dans l'application particulière, entre 10¹⁶ et 10¹⁸ cm⁻³, préférentiellement supérieure à 10¹⁷cm⁻³.

L'épaisseur de la première couche semiconductrice 121 est comprise entre 50 nm et 50 µm et est adaptée en fonction de l'application de la structure 10.

Ainsi dans l'application particulière, la première couche semiconductrice 121 est adaptée pour filtrer les rayonnements électromagnétiques dont la longueur d'onde est comprise dans le proche infrarouge. Une telle adaptation est obtenue en fournissant une première couche semiconductrice 121 de largeur de bande interdite adaptée et dont l'épaisseur est égale à plusieurs fois la longueur d'onde du rayonnement à filtrer. A cet effet, la première couche semiconductrice 121 présente une épaisseur comprise entre 5 et 50 µm.

La première couche semiconductrice 121 présente une région 121a dans laquelle la face, qui est opposée à la première face du support, est en retrait par rapport au plan de surface formé par le reste de la face de la première couche semiconductrice 121. La région 121a de la première couche peut être, comme illustré sur la figure 3, de forme carrée. La région 121a de la première couche est en contact avec la deuxième couche semiconductrice 122. La deuxième couche semiconductrice 122 s'étend principalement le long de la région 121a de la face de la première couche semiconductrice 121.

En variante, la première couche semiconductrice 121 peut ne pas présenter de région en retrait. La deuxième couche semiconductrice 122 est alors formée dans la troisième couche semiconductrice 123, et vient affleurer la première couche semiconductrice 121.

La portion de la première couche semiconductrice 121 qui est en contact avec la deuxième couche semiconductrice 122 forme une première zone semiconductrice 11 de la structure 10.

La deuxième couche semiconductrice 122 est une couche semiconductrice adaptée pour les applications optoélectroniques. La deuxième couche semiconductrice 122 est préférentiellement réalisée dans un matériau semiconducteur à gap direct, tel que l'arséniure de gallium (GaAs) et le phosphure d'indium (InP). La deuxième couche semiconductrice présente le deuxième type de conductivité qui est opposé au premier type de conductivité.

La deuxième couche semiconductrice 122 présente sur la majeure partie de son épaisseur une largeur de bande interdite dont l'énergie est supérieure à celle d'un rayonnement électromagnétique dont la longueur d'onde est comprise dans la première gamme de fonctionnement. Pour permettre une transition entre la première couche semiconductrice 121 et le mesa 130, la largeur de bande interdite de la deuxième couche semiconductrice 122 peut varier de la première couche semiconductrice 121 vers le mesa 130 du minimum de largeur en bande interdite de la première couche semiconductrice 121 à la largeur de bande interdite du mesa 130 au niveau de sa base.

La concentration en porteurs majoritaires de la deuxième couche semiconductrice 122 est au moins dix fois inférieure à la concentration de porteurs majoritaires de la première couche semiconductrice 121. La concentration en porteurs majoritaires de la seconde couche semiconductrice 122 est comprise entre 10¹⁴ et 10¹⁸ cm⁻³.

Dans l'application particulière, la deuxième couche semiconductrice 122 est une couche en tellurure de mercure-cadmium du type Cd_{X}Hg_{1-X}Te avec X la proportion en cadmium comprise entre 0,2 et 1. La valeur minimum de la proportion en cadmium X est choisie en fonction de la gamme de fonctionnement de manière à ce que la deuxième couche semiconductrice 122 présente une largeur de bande interdite dont l'énergie est supérieure à celle d'un rayonnement électromagnétique dont la longueur d'onde est comprise dans la gamme de fonctionnement ceci selon le même principe que la première couche semiconductrice 121.

Dans l'application particulière, la deuxième couche semiconductrice présente une largeur de bande interdite qui varie continûment le long de l'épaisseur de la deuxième couche semiconductrice 122. Une telle variation est obtenue, comme l'illustre la figure 2, en variant la concentration en cadmium le long de l'épaisseur de la deuxième couche semiconductrice 122.

La deuxième couche semiconductrice 122 forme avec la première couche semiconductrice 121 une jonction semiconductrice.

Le mesa 130 est en contact avec la deuxième couche semiconductrice 122 sur la face de la deuxième couche semiconductrice 122 qui est opposée à la première couche semiconductrice 121.

Le mesa 130, tel qu'illustré sur la figure 3 présente une forme générale de tronc de pyramide de base carrée. Le mesa 130 peut également présenter, selon des variantes de l'invention une forme générale tronconique ou de tronc de prisme. Le mesa 130 est en contact avec la deuxième couche semiconductrice 122 par sa base. L'angle de chacune des faces du mesa 130 par rapport à la base est compris entre 60° et 90°. Chaque côté du mesa 130 présente une largeur moyenne sensiblement égale à λ₀/2n_{eff} avec n_{eff} l'indice effectif moyen du mesa 130 dans la gamme de fonctionnement.

Le rapport l'indice effectif moyen n_{eff} sur l'indice optique du support nᵢ est supérieur à 1, préférentiellement à 1,5 et de manière particulièrement avantageuse supérieur à 2.

La hauteur du mésa 130 est à la fois adaptée à la gamme de fonctionnement et à la problématique de réduction du courant d'obscurité. Ainsi le mesa 130 présente une hauteur suffisante pour absorber un rayonnement électromagnétique 2 dont la longueur d'onde est comprise dans la gamme de fonctionnement et suffisamment faible pour que le mesa 130 ne présente pas un volume trop important à l'origine du courant d'obscurité.

Ainsi dans l'application particulière pour une gamme de fonctionnement dont la longueur d'onde λ₀ est égale à 4 µm, la largeur et la hauteur du mesa peuvent être choisi comme étant respectivement égale à 750 nm et 250 nm.

Le mesa 130 est réalisé dans un matériau semiconducteur à gap direct. Le matériau semiconducteur est un matériau semiconducteur adapté pour les applications optoélectroniques, tel que l'arséniure de gallium (GaAs) et le phosphure d'indium (InP). Le matériau constituant le mesa 130 présente le deuxième type de conductivité.

Le mesa 130 présente une largeur de bande interdite moyenne dont l'énergie est inférieure à l'énergie d'un rayonnement électromagnétique 2 dont la longueur d'onde est comprise dans la gamme de fonctionnement.

Le mesa 130 et la deuxième couche semiconductrice 122 forment la deuxième zone semiconductrice 12. Les parties du mesa 130 et de la deuxième couche semiconductrice 122 dont la concentration en porteurs majoritaires est inférieure à au moins dix fois la concentration en porteurs majoritaires de la première couche semiconductrice 121 forment la portion de la deuxième zone semiconductrice 12. Ladite portion de la deuxième zone semiconductrice 12 est essentiellement ménagée dans le mesa.

La première couche semiconductrice 121 est en contact avec une troisième couche semiconductrice 123, ceci au niveau de la face qui est opposée au support 100 et ceci en dehors de la région 121a. La troisième couche semiconductrice 123 s'étend le long de la première couche semiconductrice 121 sur la surface de sa face qui opposée au support et qui n'est pas en contact avec la deuxième couche semiconductrice 122.

La troisième couche semiconductrice 123 est une couche semiconductrice adaptée pour les applications optoélectroniques. La troisième couche semiconductrice 123 est préférentiellement réalisée dans un matériau semiconducteur à gap direct tel que l'arséniure de gallium (GaAs) et le phosphure d'indium (InP). La troisème couche semiconductrice 123 présente une conductivité du premier type.

La concentration en porteurs majoritaires dans la troisième couche semiconductrice 123 peut être au moins égale à celle de la première couche semiconductrice 121, et préférentiellement supérieure à cette dernière.

La face de la troisième couche semiconductrice 123 qui est opposée à la deuxième couche semiconductrice 122 et le sommet du mesa 130 sont en contact avec une première couche dite isolante 153. La première couche isolante 153 est adaptée pour passiver la surface du mesa 130 et de la troisième couche semiconductrice 123 qu'elle recouvre. Elle présente une propriété d'isolation électrique. Une telle propriété électrique peut être obtenue par une augmentation de la largeur de bande interdite le long de l'épaisseur de la première couche isolante 153 à partie de sa face qui est en contact avec la troisième couche semiconductrice 123 et le mesa 130 vers la face qui est opposée à la troisième couche semiconductrice 123 et au mesa 130.

La première couche isolante 153 présente une épaisseur de l'ordre de quelques dizaines à quelques centaines de nanomètres.

Une telle première couche isolante 153 peut être obtenue, par exemple et dans le cas particulier, en réalisant la première couche isolante dans un tellurure de cadmium-mercure avec la concentration en cadmium qui est variée, le long de l'épaisseur de la couche, en direction de la face qui est opposée à la troisième couche semiconductrice 123 et au mesa 130, d'une valeur correspondant à la concentration dans le mesa 130 à une concentration en cadmium égale à 1 c'est-à-dire du CdTe.

La première couche isolante 153 est en contact, sur sa face qui est opposée à la troisième couche semiconductrice 123 et au mesa 130, avec une deuxième couche isolante 154. La deuxième couche isolante 154 s'étend le long de la première couche isolante 153 sur sa face qui est opposée à la troisième couche semiconductrice 123 et au mesa 130.

La deuxième couche isolante 154 est réalisée dans un matériau isolant classiquement utilisé dans la micro-électronique ou l'opto-électronique, comme par exemple du dioxyde de silicium (SiO₂), du nitrure de silicium (SiN), du sulphure de zinc (ZnS).

La deuxième couche isolante 154 présente une épaisseur de quelques dizaines à quelques centaines de nanomètres.

Dans l'application particulière la deuxième couche isolante 154 est préférentiellement du sulphure de zinc (ZnS).

La deuxième couche isolante 154 est en contact sur sa face qui est opposée à la première couche isolante 153 avec une troisième couche isolante 155.

La troisième couche isolante 155 s'étend le long de la la face de la deuxième couche isolante 154 qui est opposée à la première couche isolante 153.

La troisième couche isolante 155 est réalisée dans un matériau isolant classiquement utilisé dans la micro-électronique ou l'opto-électronique, comme par exemple du dioxyde de silicium (SiO₂), du nitrure de silicium (SiN), du tellurure de cadmium (CdTe).

La troisième couche isolante 155 présente une épaisseur de quelques dizaines de nanomètres à quelques centaines de nanomètres.

Dans l'application particulière la troisième couche isolante 155 est préférentiellement du sulfure de zinc (ZnS).

Selon une variante de l'invention non illustrée, la troisième couche isolante 155 peut être absente, la quatrième couche isolante 156, illustrée sur la figure 1, étant, selon cette variante, déposée directement sur la deuxième couche isolante 154.

La face de la couche isolante 155 qui est opposée au support forme un plan de surface de la structure 10.

La première, la deuxième et la troisième couche isolante 153, 154, 155 forment ensemble pour leurs parties s'étendant le long de la troisième couche semiconductrice 123 la première zone isolante 151, tandis que les parties de la première, deuxième et troisième couche isolante 153, 154, 155 qui sont présentent au niveau du mesa forment la deuxième zone isolante 152.

La troisième couche semiconductrice 123, les première, deuxième et troisième couches isolantes 153, 154, 155 en ne recouvrant pas la région 121a de la première couche semiconductrice 121 délimitent, avec la surface de la face la deuxième couche semiconductrice 122 opposée au support 100 et qui n'est pas recouverte par le mesa 130, le volume de la zone réfléchissante 141.

La zone réfléchissante 141 est en contact électrique avec la deuxième couche semiconductrice 122, sur la surface de sa face opposée au support 100 qui n'est pas en contact avec la base du mesa 130, et les côtés du mesa 130. La zone réfléchissante 141 est formée dans un matériau réfléchissant au moins partiellement, et préférentiellement totalement, les rayonnements électromagnétiques dont l'énergie est comprise dans la gamme de fonctionnement.

Le matériau formant la zone réfléchissante 141 est un matériau conducteur qui est adapté pour former avec la deuxième couche semiconductrice 122 et le mesa 130 un contact électrique de bonne qualité qui est préférentiellement ohmique. Le matériau formant la zone réfléchissante est préférentiellement de l'or (Au).

Dans l'application particulière la zone réfléchissante 141 est réalisée dans de l'or (Au), l'interface entre la zone réfléchissante 141 et le mesa 130 et la deuxième couche semiconductrice 122 est améliorée au moyen d'une couche d'accroche en métal sélectionné par exemple dans le groupe comportant le chrome (Cr), le titane (Ti) et le tantale (Ta).

Dans l'application particulière illustrée sur la figure 1, la zone réfléchissante 141 est en contact électrique avec un premier plot 142 de contact adapté pour autoriser un contact électrique par hybridation par billes d'indium. Une telle électrode, est, comme illustrée sur la figure 1, en saillie du plan de surface de la structure.

La troisième couche semiconductrice 123, la première, la deuxième et la troisième couche isolante 153, 154, 155 présentent une percée formant un passage pour le deuxième contact électrique. Le deuxième contact électrique comporte un via conducteur 143 passant par le passage.

Dans l'application particulière illustrée sur la figure 1, le deuxième contact comporte un deuxième plot 144 de contact en contact électrique avec le via et étant en saillie du plan de surface de la structure 10. Le deuxième plot 144 de contact est adapté pour autoriser un contact électrique par hybridation par billes d'indium.

Une telle structure 10 permet, comme cela est illustré sur la figure 1, de focaliser dans la cavité formée par le mesa 130, le rayonnement électromagnétique 2 reçu par la structure 10 dont la longueur d'onde est comprise dans la gamme de longueur d'onde sur une zone de la surface du substrat 100 qui s'étend de part et d'autre du mesa 130 sur λ₀/2nᵢ.

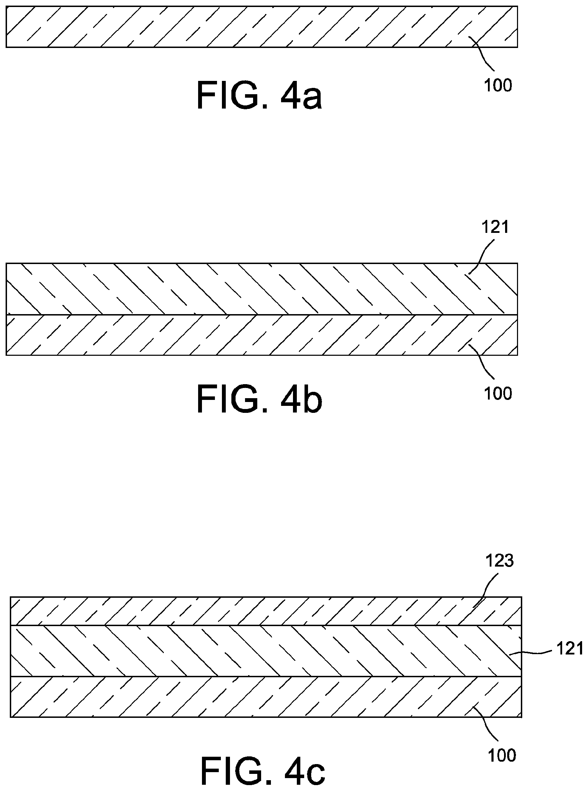

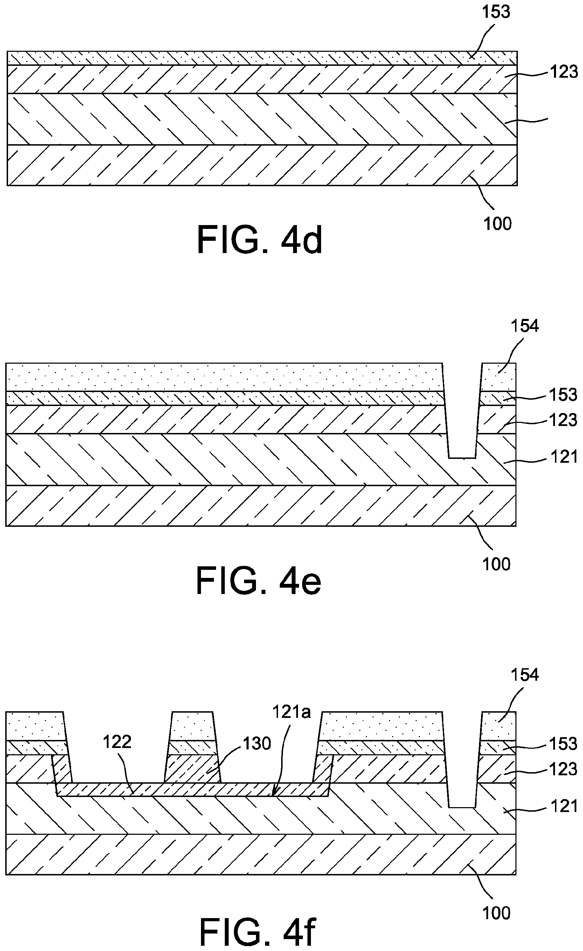

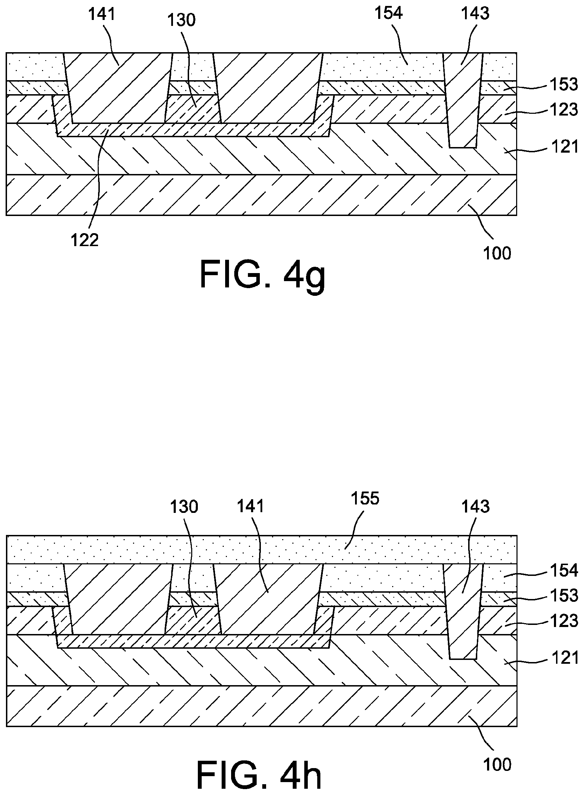

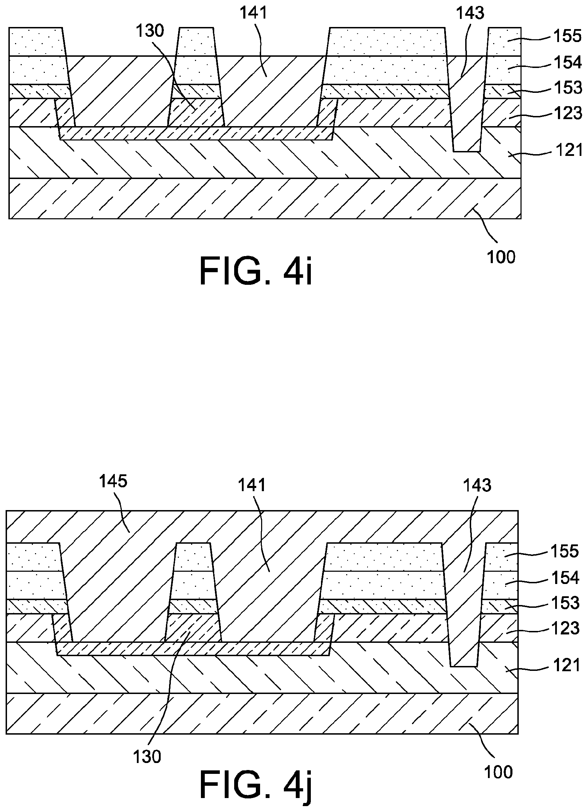

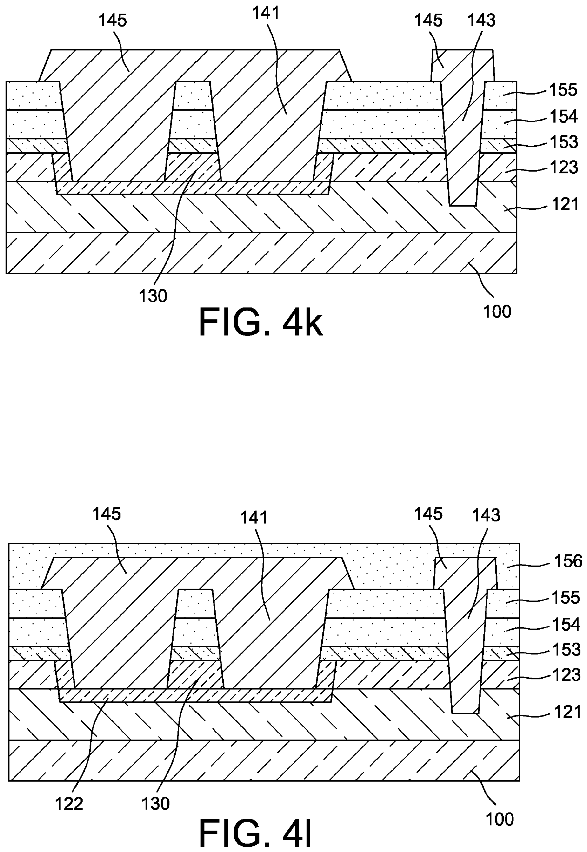

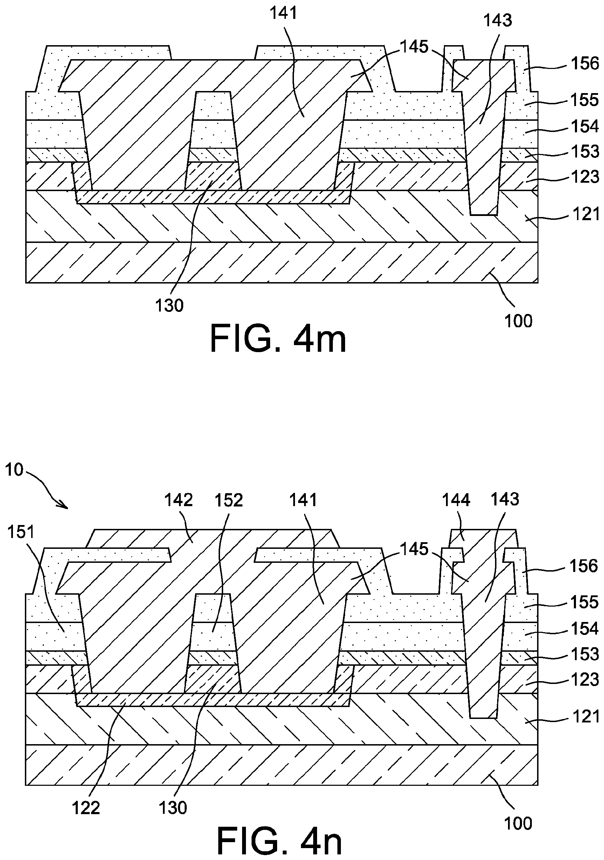

Une telle structure 10, lorsqu'elle correspond à l'application particulière illustrée sur la figure 1, peut être fabriquée par un procédé de fabrication tel qu'illustré sur les figures 4a à 4n. Un tel procédé de fabrication comporte les étapes consistant à :
- fournir le support 100 semiconducteur, tel que cela est illustré sur la figure 4a,
- former, comme illustré sur la figure 4b, la première couche semiconductrice 121 en contact avec la première face du support 100,
- former, comme illustré sur la figure 4c, la troisième couche semiconductrice 123 en contact avec la face de la première couche semiconductrice 121 qui est opposée au support,
- former, comme illustré sur la figure 4d, la première couche isolante 153 en contact avec la face de la troisième couche semiconductrice 123 qui est opposée à la première couche semiconductrice 121,
- former, comme illustré sur la figure 4e, la deuxième couche isolante 154 en contact avec la face de la première couche isolante 153 qui est opposée à la troisième couche semiconductrice 123,
- former, comme illustré sur la figure 4e, le passage, pour le deuxième contact électrique, au travers de la première et de la deuxième couche isolante 153, 154, de la troisième couche semiconductrice 123 et partiellement (ou totalement) de la première couche semiconductrice 121,
- graver, au niveau de la région 121a de la première couche semiconductrice 121, les première et deuxième couches isolantes 153, 154, la troisième couche semiconductrice 123 et une partie de la première couche semiconductrice 121 de manière à former le mesa 130 et la deuxième couche semiconductrice 122, l'étape de gravure permettant un changement de la concentration en porteur de la partie de la première et de la deuxième couche semiconductrice 121, 122 formant le mesa 130 et la deuxième couche semiconductrice 122, comme cela est illustré sur la figure 4f,
- remplir, comme illustré sur la figure 4g, le passage et l'espace de la première et deuxième couches isolantes 153, 154, la troisième couche semiconductrice 123 et une partie de la première couche semiconductrice 121, qui a été gravée, avec un matériau au moins partiellement réfléchissant dans la gamme de fonctionnement de manière à former le deuxième contact électrique et la zone réfléchissante 141, ladite zone réfléchissante 141 étant en contact électrique avec les côtés du mesa 130 et avec la deuxième couche semiconductrice 122, la zone réfléchissante formant le premier contact électrique,
- remplir, comme illustré sur la figure 4g, l'espace réalisé à lors de l'étape gravure au niveau de la région 121a illustrée sur la figure 4e, par un matériau électriquement conducteur pour former un contact électrique 143,
- former le cas échéant, comme illustré sur la figure 4h, la troisième couche isolante 155 en contact avec la face de la deuxième couche isolante 154 opposée à la première couche isolante 153 et avec le matériau au moins partiellement réfléchissant formant la zone réfléchissante 141 et le matériau formant le contact électrique 143,
- retirer, comme illustré sur la figure 4i, la partie de la troisième couche isolante 155 qui est en contact avec la zone réfléchissante 141 et celle qui est en contact avec le contact électrique 143,
- déposer, comme illustré sur la figure 4j, une première couche de matériau au moins partiellement réfléchissant 145 en contact avec la troisième couche isolante 155 et avec le matériau au moins partiellement réfléchissant présent dans le passage et celui composant la zone réfléchissante 141 et avec le contact électrique 143,
- retirer, comme illustré sur la figure 4k, la majeure partie de la première couche de matériau au moins partiellement réfléchissant 145 qui est en contact avec la troisième couche de matériau isolant 155,
- former, comme illustré sur la figure 4l, une quatrième couche isolante 156, réalisée dans le même matériau isolant que la troisième couche isolante 155, ladite quatrième couche isolante 156 étant en contact avec la troisième couche isolante 155 sur sa face qui est opposée à la deuxième couche isolante 154 et avec la première couche de matériau au moins partiellement réfléchissant 145,
- retirer, comme illustré sur la figure 4m, une partie de la quatrième couche isolante 156 pour réaliser un passage vers le matériau 141 d'une part et vers le matériau 143 d'autre part,
- former, comme illustré sur la figure 4n, des contacts électriques 142 et 144, en un matériau électriquement conducteur, en contact électrique avec la partie de la première couche au moins partiellement réfléchissante 145.

L'étape de gravure lors de la formation du mesa 130 et de la deuxième zone, est particulièrement liée à l'application particulière. En effet, le changement de type de conductivité obtenue lors de cette étape de gravure est permis par une particularité de l'obtention de la conductivité du type dans lequel les porteurs majoritaires sont des trous. Dans les tellurures de mercure-cadmium Cd_{X}Hg_{X-1}Te, le type de conductivité peut être obtenu au moyen de lacunes de mercure Hg qui peuvent être au moins en partie comblées par diffusion de mercure lors de la gravure appropriée d'une zone voisine. Ainsi, avec une première et une troisième couche semiconductrice 121, 123 comprenant, en outre, une concentration faible en impuretés donneuses d'électrons, la gravure de la zone, et le comblement des lacunes, et donc l'inhibition des trous, permet d'inverser le type de conductivité.

Par ailleurs, de part cette étape de gravure, le mesa 130 et la deuxième couche semiconductrice 122 présentent au niveau de leur surface qui est respectivement sur les faces du tronc de pyramide et sur la face plane en contact avec la zone réfléchissante 141 qui est opposée au support, une épaisseur le long de laquelle la concentration en porteurs majoritaires est supérieure à la concentration du reste du mesa 130 et du reste de la deuxième couche semiconductrice 122. Une telle épaisseur au niveau respectivement des faces du mesa 130 et de ladite surface de la deuxième couche semiconductrice 122 sur lesquelles la concentration en porteurs majoritaires est supérieure permet de fournir un contact électrique amélioré avec la zone réfléchissante 141.

Un procédé de fabrication d'une structure 10 dont les matériaux n'autorisent pas un changement de type de conductivité, est également envisageable sans que l'on sorte du cadre de l'invention. Selon cette possibilité, le procédé de fabrication comporte alors des étapes supplémentaires de gravure et de formation de la deuxième couche semiconductrice 122 et du mesa 130.

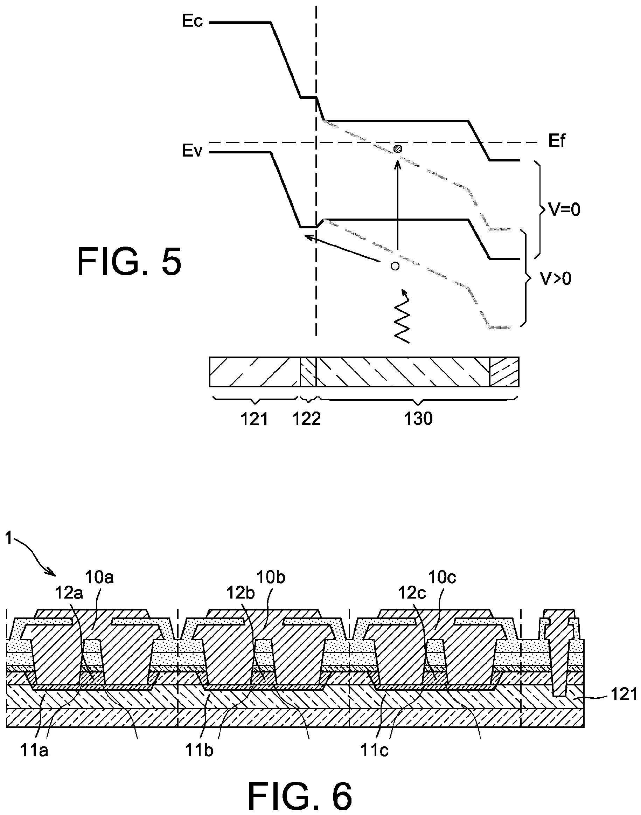

Une structure 10 obtenue au moyen d'un tel procédé de fabrication présente un diagramme de bandes le long de la première, de la deuxième couche semiconductrice 121, 122 et du mesa 130, et selon les traits mixtes présents sur la figure 2, tel que schématisé sur la figure 5.

Sur la figure 5, les lignes tiretées illustrent l'influence, en fonctionnement, de la polarisation en inverse de la structure sur le diagramme de bande de cette même structure. On peut ainsi voir une forte différence entre la concentration en porteurs majoritaires dans la première couche semiconductrice 121 et dans la deuxième couche semiconductrice 122 et le mesa 130. Cet effet est schématiquement amplifié sur la figure 5, la chute de potentiel illustrée sur cette figure, pour des raisons de compréhension, étant totalement absorbée le long de l'épaisseur du mesa 130.

Ainsi, on peut voir sur la figure 5 qu'une faible différence de potentiel appliquée entre le premier et le deuxième contact électrique 142, 144, suffit pour induire une déplétion des porteurs majoritaires sur la presque totalité de l'épaisseur du mesa 130. Il en résulte à la fois une réduction du courant d'obscurité dans la jonction, la déplétion des porteurs majoritaires réduisant les risques de transition paires électron-trou de type Auger dans le mesa, et une séparation des porteurs générés par le rayonnement électromagnétiques qui est obtenue par écoulement, en raison de la différence de potentiel, et non par diffusion. Ces deux mécanismes permettent d'améliorer le rapport signal sur bruit de la structure.

L'amélioration du signal sur bruit qui en résulte s'ajoute à celle qui est liée à la focalisation du rayonnement électromagnétique obtenu au moyen de la cavité Fabry-Pérot, qui permet de réduire le volume fonctionnel de la structure au mesa avec un faible impact sur la surface de collection du rayonnement électromagnétique (voir la zone de collection 20 sur la figure 1) et par le fait que la première zone de la structure, celle formée dans la première couche semiconductrice, présente une forte largeur de bande interdite, donc une faible génération de courant d'obscurité.

L'invention concerne également un composant 1 semiconducteur, tel qu'illustré sur la figure 6, comportant une pluralité de structures 10a, 10b, 10c selon l'invention. Avec un tel composant 1, les structures 10a, 10b, 10c sont préférentiellement agencées en un réseau en deux dimensions s'étendant le long du substrat. Dans un tel composant 1, la première couche semiconductrice 121 est commune à l'ensemble des structures 10a, 10b, 10c, autorisant une polarisation commune de l'ensemble des première zones des structures du composant tandis que la deuxième zone de chacune des structure est polarisée indépendamment.

Le principe de placer des structures selon un tel agencement étant connu par ailleurs, un tel composant n'est pas décrit plus en détail dans ce document.

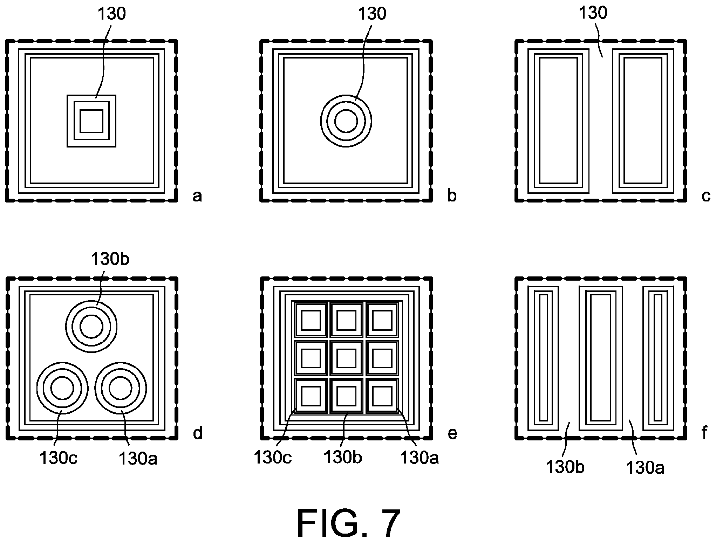

Les figures 7a, 7b et 7c illustrent trois exemple de conformation du mesa 130. Sur la figure 7a, le mesa prend une forme en tronc de pyramide à base carrée tandis que sur les figure 7b et 7c, le mesa prend respectivement une forme tronconique et de tronc de prisme.

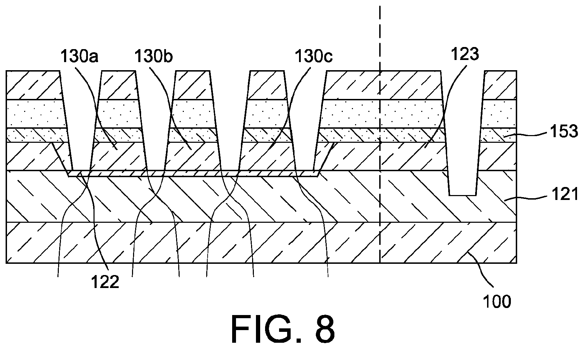

Les figures 7d à 7f et la figure 8 illustrent des possibilités de l'invention dans lesquelles la structure comporte plusieurs mesas 130a, 130b, 130c formant chacun une cavité de type Fabry-Pérot associé chacun à une jonction semiconductrice. Selon une première possibilité, illustrée sur les figures 7d, 7e, 7f et 8, les mesas peuvent avoir le même facteur de forme et selon une deuxième possibilité de l'invention, non illustrée, les mesas peuvent avoir des facteurs de forme différents.

Selon la première possibilité, les mesas 130a , 130b, 130c présentent un même facteur de forme adapté pour la première gamme de fonctionnement. Ainsi, selon le principe illustré sur la figure 7, chacune des cavités formées par l'un des mesas permet de focaliser une partie du rayonnement électromagnétique reçu par la structure permettant d'augmenter la surface sur laquelle est collecté le rayonnement électromagnétique. Selon, cette possibilité, l'agencement des cavités pouvant être périodique, la périodicité sera préférentiellement différente de λ₀/nᵢ avec l'indice optique de la zone de réception du rayonnement électromagnétique, c'est-à-dire l'indice optique du support.

Selon la deuxième possibilité, les mesas d'une même structure, en présentant chacun un facteur de forme qui est différent, focalisent le rayonnement électromagnétique reçu par la structure sur une gamme de longueurs d'onde différente et permettent ainsi d'augmenter la gamme de longueurs d'onde dans laquelle la structure fonctionne. En effet, chacune des jonctions, par la focalisation du rayonnement dans une gamme de longueurs d'onde donnée, sera principalement sensible au rayonnement électromagnétique dans ladite longueur d'onde donnée, les signaux des différentes jonctions s'additionnant, la structure présente une sensibilité sur une gamme de longueurs d'onde comportant les gammes de longueurs d'onde de chacune des cavités.

Selon cette même deuxième possibilité, le matériau formant chacun des mesas 130a,b,c présente une largeur de bande interdite dont l'énergie est inférieure à celui d'un rayonnement électromagnétique compris dans la gamme de longueurs d'onde comportant la plus faible énergie. De même la première et la seconde couche semiconductrice présentent une largeur de bande interdite dont l'énergie est supérieure à l'énergie d'un rayonnement électromagnétique 2 dont la longueur d'onde est comprise dans la gamme de longueurs d'onde comportant la plus haute énergie.

Selon une troisième possibilité non illustrée, la structure 10 peut ne pas présenter une partie, ou la totalité, de l'empilement constitué par la première, la deuxième et la troisième couche isolante 153, 154, 155 qui est en contact avec le sommet du mesa 130. En effet, un tel empilement ne participant pas au confinement de la cavité Fabry-Pérot, son absence n'influence en rien le fonctionnement de la structure.

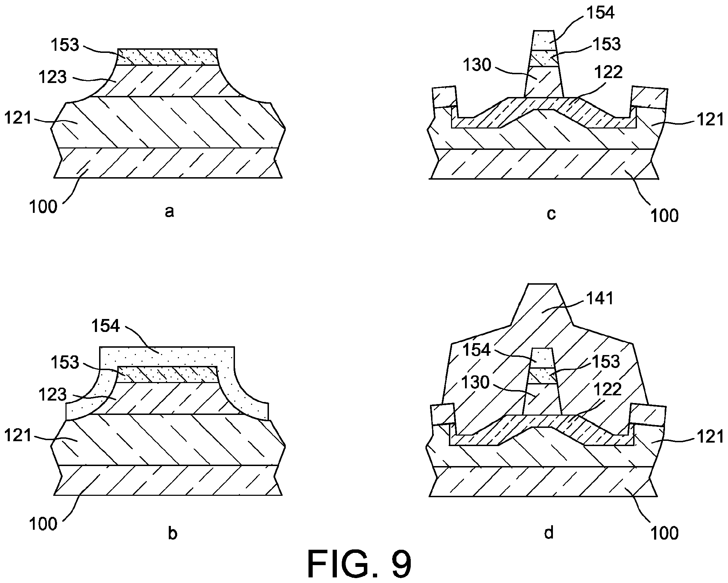

Selon un deuxième mode de réalisation de la structure 10 dont les principales étapes de fabrication sont illustrées sur les figures 9, la structure 10 peut présenter une deuxième couche semiconductrice 122 de taille réduite vis-à-vis d'une structure 10 selon le premier mode de réalisation.

Le procédé de fabrication d'une structure 10 selon le deuxième mode de réalisation se différencie du procédé de fabrication d'une structure 10 selon le premier mode de réalisation en ce qu'elle comporte une étape supplémentaire consistant, après dépôt de la première couche isolante 153, à supprimer la partie de l'empilement formée par la première couche isolante 153 et la troisième couche semiconductrice 123, qui n'est pas au niveau de la région 121a de la première couche semiconductrice 121. Selon cette possibilité dans l'étape de formation de la deuxième couche isolante 154, la deuxième couche isolante 154 est en contact, pour sa partie qui n'est pas au niveau de la région 121a de la première couche semiconductrice 121, avec la première couche semiconductrice 121 sur sa face qui est opposée au support 100.

Une telle structure 10 présente notamment comme avantage, vis-à-vis d'une structure selon l'art antérieure, de présenter une deuxième couche semiconductrice 122 de volume réduit. Une telle deuxième couche semiconductrice 122 dont le volume est réduit permet de limiter le courant d'obscurité qui pourrait être généré dans ladite deuxième couche semiconductrice 122.

Dans l'ensemble des modes de réalisation décrits ci-dessus dont au moins l'une des cavités est une cavité du type Fabry-Pérot, les côtés réfléchissants de chacune des cavités du type Fabry-Pérot sont obtenus au moyen d'une zone réfléchissante. Il est également envisageable sans que l'on sorte du cadre de l'invention, que les côtés réfléchissants de chacune des cavités soient formés au moyen de miroirs de Bragg. De tels miroirs de Bragg peuvent être formés, par exemple, par un empilement de couches semiconductrices.

Il est également envisageable, sans que l'on sorte du cadre de l'invention, que le ou les mesas soient partiellement ou totalement dépourvus de contact avec les couches isolantes 153, 154, 155.
Selon une autre possibilité de l'invention, non illustrée, il est également possible, ceci sans que l'on sort du cadre de l'invention, que la structure ne comporte pas de support. Conformément à cette possibilité, le rayonnement électromagnétique est reçu par la structure au travers d'une zone d'air d'indice optique nᵢ égal à 1.

## Revendications

1. Structure (10) semiconductrice destinée à recevoir un rayonnement électromagnétique (2) dans une première gamme de longueurs d'onde, dite de fonctionnement, qui est centrée autour d'une longueur d'onde λ₀, comportant :
- une première zone semiconductrice (11) d'un premier type de conductivité,
- une deuxième zone semiconductrice (12) d'un deuxième type de conductivité opposé au premier type de conductivité, la deuxième zone semiconductrice (12) étant en contact avec la première zone semiconductrice (11) de manière à former une jonction semiconductrice,
la structure (10) **étant caractérisée en ce que** la deuxième zone semiconductrice (12) présente une portion dont la concentration en porteurs majoritaires est au moins inférieure de dix fois à la concentration en porteurs majoritaires de la première zone semiconductrice (11), ladite portion étant en contact avec la première zone semiconductrice (11), **et en ce que** ladite portion de la deuxième zone semiconductrice (12) est essentiellement ménagée dans une première cavité adaptée pour focaliser dans la première cavité au moins une partie du rayonnement électromagnétique (2) reçu, dans laquelle la première cavité est une cavité du type Fabry-Pérot, la première cavité présentant selon au moins une direction de confinement une dimension moyenne sensiblement égale à λ₀/2n_{eff} avec n_{eff} l'indice effectif moyen dans la deuxième zone, et
dans laquelle Le rayonnement électromagnétique est reçu dans un milieu d'indice optique nᵢ, dit indice incident, le rapport entre l'indice effectif et l'indice incident n_{eff}/nᵢ étant supérieur à 1, préférentiellement sensiblement supérieur à 1,5, et encore plus préférentiellement supérieur à 2.

2. Structure (10) selon la revendication 1, dans laquelle la dimension de la première cavité selon la direction de confinement est une dimension variable, ladite dimension diminuant préférentiellement selon la direction dirigée de la première zone semiconductrice (11) vers la deuxième zone semiconductrice (12).

3. Structure (10) selon la revendication précédente, dans laquelle la première et la deuxième zone semiconductrice (11, 12) présentent des largeurs de bande interdite d'énergies différentes, la première zone semiconductrice (11) présentant une largeur de bande interdite moyenne d'énergie supérieure à celle d'un rayonnement dont la longueur d'onde est comprise dans la gamme de fonctionnement.

4. Structure (10) selon la revendication précédente, dans laquelle la deuxième zone semiconductrice (12) comporte, outre ladite portion, une partie non ménagée dans la cavité et présentant une largeur de bande interdite moyenne d'énergie supérieure à celle d'un rayonnement électromagnétique dont la longueur d'onde est comprise dans la gamme de fonctionnement, et ladite portion présentant une largeur de bande interdite moyenne d'énergie inférieure à celle d'un rayonnement électromagnétique dont la longueur d'onde est comprise dans la première gamme de fonctionnement.

5. Structure (10) selon l'une quelconque des revendications précédentes, dans laquelle les première et deuxième zones semiconductrices (11, 12) sont réalisées dans des matériaux semiconducteurs composés essentiellement d'au moins trois mêmes éléments dont la concentration en au moins l'un de ces éléments permet de faire varier la largeur de bande interdite, lesdits éléments étant préférentiellement le cadmium (Cd), le mercure (Hg) et le tellure (Te).

6. Structure (10) selon l'une quelconque des revendications précédentes, dans laquelle il est prévu :
- un support (100) transparent dans la gamme de fonctionnement, le substrat comportant une première et une seconde face,
- une première couche semiconductrice (121) du premier type de conductivité s'étendant le long de la première face en contact avec cette même première face, une portion de ladite première couche semiconductrice (121) formant la première zone semiconductrice,
- un mesa semiconducteur (130) en contact direct, ou par l'intermédiaire d'une deuxième couche semiconductrice du deuxième type de conductivité, avec la face de la première couche semiconductrice (121) qui est opposée à la première face, ledit mesa (130) présentant le deuxième type de conductivité et une concentration en porteurs majoritaires qui est au moins dix fois inférieure à celle de la première couche semiconductrice (121), ledit mesa (130) formant au moins partiellement la deuxième zone semiconductrice 12, le mesa (130) présentant au moins une direction, la direction de confinement, selon laquelle le mesa (130) présente une dimension moyenne de λ₀/2n_{eff,} la partie du mesa formant au moins partiellement la portion de la deuxième zone semiconductrice,
- une zone (141), dite réfléchissante, d'un matériau au moins partiellement réfléchissant dans la gamme fonctionnement, ladite zone réfléchissante (141) recouvrant au moins une partie du mesa (130) de manière à former la première cavité de type Fabry-Pérot qui présente une dimension moyenne sensiblement égale à λ₀/2n_{eff} selon la direction de confinement.

7. Structure (10) selon l'une quelconque des revendications précédentes, dans laquelle il est en outre prévu au moins une troisième et une quatrième zone semiconductrice présentant respectivement le premier et le deuxième type de conductivité, la troisième et la quatrième zone semiconductrice étant en contact l'une avec l'autre de manière à former une jonction semiconductrice, la quatrième zone semiconductrice présente une deuxième portion dont la concentration en porteurs majoritaires est au moins inférieure de dix fois la concentration en porteurs majoritaires de la troisième zone semiconductrice, ladite deuxième portion étant la portion de la quatrième zone semiconductrice qui est en contact avec la troisième zone semiconductrice, la quatrième zone semiconductrice est essentiellement ménagée dans une deuxième cavité, ladite deuxième cavité étant adaptée pour concentrer dans la deuxième cavité une partie du rayonnement électromagnétique (2) qui est reçu par la structure (10) et dont la longueur d'onde est comprise dans une gamme de longueurs d'onde dite deuxième gamme de fonctionnement.

8. Structure (10) selon la revendication précédente, dans laquelle la deuxième gamme de fonctionnement est sensiblement identique à la première gamme de fonctionnement.

9. Structure (10) selon la revendication 7, dans laquelle la deuxième gamme de fonctionnement est différente de la première gamme de fonctionnement, la première et la deuxième gamme de fonctionnement étant préférentiellement choisies pour couvrir une gamme de longueurs d'onde continue.

10. Composant semiconducteur (1) comportant une pluralité de structures (10) semiconductrices destinées à recevoir un rayonnement électromagnétique (2), **caractérisé en ce qu'**au moins l'une des structures (10) est une structure selon l'une quelconque des précédentes revendications.

11. Procédé de fabrication d'une structure (10) destinée à recevoir un rayonnement électromagnétique (2) dans une première gamme de longueurs d'onde, dite de fonctionnement, qui est centrée autour d'une longueur d'onde λ₀, **caractérisée en ce qu**'il comporte les étapes consistant à :
- fournir un support (100) présentant une première et une seconde face,
- former une première couche semiconductrice (121) d'un premier type de conductivité, au moins une portion de ladite première couche semiconductrice (121) formant une première zone semiconductrice (11),
- former un mesa (130) semiconducteur en contact avec la première couche semiconductrice (121), ledit mesa (130) étant d'un deuxième type de conductivité opposé au premier type de conductivité et comportant une portion, en contact avec la première couche semiconductrice (121), dont la concentration en porteurs majoritaires est au moins inférieure de dix fois la concentration en porteurs majoritaires de la première couche semiconductrice (121), le mesa (130) présentant au moins une direction, dite de confinement, selon laquelle le mesa (130) présente une dimension moyenne de λ₀/2n_{eff}, avec n_{eff} l'indice effectif moyen dans la deuxième zone, le mesa (130) formant au moins partiellement une deuxième zone semiconductrice (12),
- déposer une couche d'un matériau au moins partiellement réfléchissant dans la gamme de fonctionnement de manière à former une zone dite réfléchissante, la zone réfléchissante (141) recouvrant au moins une partie du mesa (130) de manière à former une première cavité de type Fabry-Pérot qui présente une dimension moyenne sensiblement égale à λ₀/2n_{eff} selon la direction de confinement,
dans lequel Le rayonnement électromagnétique est reçu dans un milieu d'indice optique nᵢ, dit indice incident, le rapport entre l'indice effectif et l'indice incident n_{eff}/nᵢ étant supérieur à 1, préférentiellement sensiblement supérieur à 1,5, et encore plus préférentiellement supérieur à 2.

12. Procédé de fabrication d'une structure (10) destinée à recevoir un rayonnement électromagnétique (2) dans une première gamme de longueurs d'onde, dite de fonctionnement, qui est centrée autour d'une longueur d'onde λ₀, **caractérisée en ce qu**'il comporte les étapes consistant à :
- fournir un support (100) présentant une première et une seconde face,
- former une première couche semiconductrice (121) d'un premier type de conductivité, au moins une portion de ladite première couche semiconductrice (121) formant une première zone semiconductrice (11),
- former une deuxième couche semiconductrice (122) en contact avec la première couche semiconductrice (121), ladite deuxième couche semiconductrice (122) étant d'un deuxième type de conductivité qui est opposé au premier type de conductivité, au moins une partie de la deuxième couche semiconductrice (122) qui est en contact avec la première couche semiconductrice (121) présentant une concentration en porteurs majoritaires qui est au moins inférieure de dix fois la concentration en porteurs majoritaires de la première couche semiconductrice (121),
- former un mesa (130) semiconducteur en contact avec la partie de la deuxième couche semiconductrice (122), ledit mesa (130) étant du deuxième type de conductivité et comportant au moins une partie, en contact avec la partie de la deuxième couche semiconductrice (121), dont la concentration en porteurs majoritaires est au moins inférieure de dix fois la concentration en porteurs majoritaires de la première couche semiconductrice (121), le mesa présentant au moins une direction, dite de confinement, selon laquelle le mesa (130) présente une dimension moyenne de λ₀/2n_{eff}, avec n_{eff} l'indice effectif moyen de la deuxième zone, le mesa (130) formant avec la deuxième couche semiconductrice (122) au moins partiellement une deuxième zone semiconductrice (12) et la partie du mesa (130) formant avec la partie de la deuxième couche semiconductrice (122) une portion de la deuxième zone,
- déposer une couche d'un matériau au moins partiellement réfléchissant dans la gamme de fonctionnement, ladite couche recouvrant au moins une partie du mesa (130) de manière à former une première cavité de type Fabry-Pérot qui présente une dimension moyenne sensiblement égale à λ₀/2n_{eff} selon la direction de confinement,
dans lequel la structure est configurée pour que le rayonnement électromagnétique soit reçu dans un milieu d'indice optique nᵢ, dit indice incident, le rapport entre l'indice effectif et l'indice incident n_{eff}/nᵢ étant supérieur à 1, préférentiellement sensiblement supérieur à 1,5, et encore plus préférentiellement supérieur à 2.

13. Procédé de fabrication selon la revendication précédente, dans lequel il est prévu avant l'étape de formation de la deuxième couche semiconductrice (122) une étape de formation d'une troisième couche semiconductrice (123) du premier type de conductivité en contact avec la première couche semiconductrice (121), la première couche et la troisième couche semiconductrice (123) comportant une concentration en impuretés, du type donneur de porteurs majoritaires du deuxième type de conductivité, qui est au moins dix fois inférieure à la concentration en porteurs majoritaires desdites première et troisième couches semiconductrices (121, 123), les étapes de formation du mesa (130) et de la deuxième couche semiconductrice (122) étant obtenues par gravure de la troisième couche conductrice (123) et une partie de la première couche conductrice (121), cette étape de gravure étant adaptée pour inhiber les porteurs majoritaires du premier type de conductivité.

## Patentansprüche

1. Halbleiterstruktur (10), welche dazu vorgesehen ist, eine elektromagnetische Strahlung (2) in einem ersten, als funktionell bezeichneten, Wellenlängenbereich zu empfangen, welcher um eine Wellenlänge λ₀ zentriert ist, umfassend:
- eine erste Halbleiterzone (11) von einem ersten Leitfähigkeitstyp,
- eine zweite Halbleiterzone (12) von einem zweiten Leitfähigkeitstyp, welcher dem ersten Leitfähigkeitstyp entgegengesetzt ist, wobei die zweite Halbleiterzone (12) in derartigem Kontakt mit der ersten Halbleiterzone (11) ist, dass ein Halbleiterübergang gebildet ist,
wobei die Struktur (10) **dadurch gekennzeichnet ist, dass** die zweite Halbleiterzone (12) einen Abschnitt aufweist, in welchem die Konzentration an Majoritätsladungsträgern wenigstens zehnmal kleiner als die Konzentration an Majoritätsladungsträgern der ersten Halbleiterzone (11) ist, wobei der Abschnitt in Kontakt mit der ersten Halbleiterzone (11) ist,
und dadurch, dass der Abschnitt der zweiten Halbleiterzone (12) im Wesentlichen in einem ersten Hohlraum vorgesehen ist, dazu eingerichtet ist, in dem ersten Hohlraum wenigstens einen Teil der empfangenen elektromagnetischen Strahlung (2) zu fokussieren,
wobei der erste Hohlraum ein Hohlraum vom Fabry-Pérot-Typ ist, wobei der erste Hohlraum entlang wenigstens einer Einschlussrichtung eine mittlere Abmessung aufweist, welche im Wesentlichen gleich λ₀/2n_{eff} ist, wobei n_{eff} der mittlere effektive Index der zweiten Zone ist, und
wobei die elektromagnetische Strahlung in einem Medium mit optischem Index nᵢ, genannt Einfallsindex, empfangen wird, wobei das Verhältnis zwischen dem effektiven Index und dem Einfallsindex n_{eff}/nᵢ größer als 1 ist, vorzugsweise wesentlich größer als 1,5 und weiter vorzugsweise größer als 2.

2. Struktur (10) nach Anspruch 1, wobei die Abmessung des ersten Hohlraums entlang der Einschlussrichtung eine variable Abmessung ist, wobei die Abmessung vorzugsweise entlang der Richtung abnimmt, welche von der ersten Halbleiterzone (11) zu der zweiten Halbleiterzone (12) gerichtet ist.

3. Struktur (10) nach dem vorhergehenden Anspruch , wobei die erste und die zweite Halbleiterzone (11, 12) unterschiedliche verbotene Energiebandbreiten aufweisen, wobei die erste Halbleiterzone (11) eine größere Größe der mittleren verbotenen Energiebandbreite aufweist als diejenige einer Strahlung, deren Wellenlänge in dem funktionellen Bereich enthalten ist.

4. Struktur (10) nach dem vorhergehenden Anspruch, wobei die zweite Halbleiterzone (12) außerhalb des Abschnitts einen Teil umfasst, welcher nicht in dem Hohlraum vorgesehen ist und eine größere mittlere verbotene Energiebandbreite als diejenige einer elektromagnetischen Strahlung aufweist, deren Wellenlänge in dem funktionellen Bereich enthalten ist, und wobei der Abschnitt eine kleinere Größe einer mittleren verbotenen Energiebandbreite aufweist als diejenige einer elektromagnetischen Strahlung, deren Wellenlänge in dem ersten funktionellen Bereich enthalten ist.

5. Struktur (10) nach einem der vorhergehenden Ansprüche, wobei die ersten und zweiten Halbleiterzonen (11, 12) aus Halbleitermaterialien hergestellt sind, welche im Wesentlichen aus wenigstens drei gleichen Elementen bestehen, wobei die Konzentration an wenigstens dem einen der Elemente es erlaubt, die Größe des verbotenen Bands zu variieren, wobei die Elemente vorzugsweise Cadmium (Cd), Quecksilber (Hg) und Tellur (Te) sind.

6. Struktur (10) nach einem der vorhergehenden Ansprüche, wobei vorgesehen sind:
- ein in dem funktionellen Bereich transparenter Träger (100), wobei das Substrat eine erste und eine zweite Fläche umfasst,
- eine erste Halbleiterschicht (121) vom ersten Leitfähigkeitstyp, welche sich entlang der ersten Fläche in Kontakt mit derselben ersten Fläche erstreckt, wobei ein Abschnitt der ersten Halbleiterschicht (121) die erste Halbleiterzone bildet,
- eine Halbleitermesa (130) in direktem Kontakt oder durch Vermittlung einer zweiten Halbleiterschicht vom zweiten Leitfähigkeitstyp mit der Fläche der ersten Halbleiterschicht (121), welche der ersten Fläche gegenüberliegt, wobei die Mesa (130) den zweiten Leitfähigkeitstyp und eine Konzentration an Majoritätsladungsträgern aufweist, welche wenigstens zehnmal kleiner als diejenige der ersten Halbleiterschicht (121) ist, wobei die Mesa (130) wenigstens teilweise die zweite Halbleiterzone (12) bildet, wobei die Mesa (130) wenigstens eine Richtung, die Einschlussrichtung, aufweist, gemäß welcher die Mesa (130) eine mittlere Abmessung von λ₀/2n_{eff} aufweist, wobei der Teil der Mesa wenigstens teilweise den Abschnitt der zweiten Halbleiterzone bildet,
- eine Zone (141), genannt reflektierend, aus einem Material, welches wenigstens teilweise in dem funktionellen Bereich reflektierend ist, wobei die reflektierende Zone (141) wenigstens einen Teil der Mesa (130) derart bedeckt, dass der erste Hohlraum vom Fabry-Pérot-Typ gebildet ist, welcher eine mittlere Abmessung aufweist, welche im Wesentlichen gleich λ₀/2n_{eff} entlang der Einschlussrichtung ist.

7. Struktur (10) nach einem der vorhergehenden Ansprüche, wobei ferner wenigstens eine dritte und eine vierte Halbleiterzone vorgesehen sind, welche den ersten bzw. den zweiten Leitfähigkeitstyp aufweisen, wobei die dritte und die vierte Halbleiterzone derart in Kontakt miteinander sind, dass ein Halbleiterübergang gebildet ist, wobei die vierte Halbleiterzone einen zweiten Abschnitt aufweist, dessen Konzentration an Majoritätsladungsträgern wenigstens zehnmal kleiner als die Konzentration an Majoritätsladungsträgern der dritten Halbleiterzone ist, wobei der zweite Abschnitt der Abschnitt der vierten Halbleiterzone ist, welcher in Kontakt mit der dritten Halbleiterzone ist, wobei die vierte Halbleiterzone im Wesentlichen in einem zweiten Hohlraum vorgesehen ist, wobei der zweite Hohlraum dazu eingerichtet ist, in dem zweiten Hohlraum einen Teil der elektromagnetischen Strahlung (2) zu konzentrieren, welche von der Struktur (10) empfangen wird und deren Wellenlänge in einem Wellenlängenbereich enthalten ist, welcher als zweiter funktioneller Bereich bezeichnet ist.

8. Struktur (10) nach dem vorhergehenden Anspruch, wobei der zweite funktionelle Bereich im Wesentlichen identisch zu dem ersten funktionellen Bereich ist.

9. Struktur (10) nach Anspruch 7, wobei der zweite funktionelle Bereich verschieden von dem ersten funktionellen Bereich ist, wobei der erste und der zweite funktionelle Bereich vorzugsweise dazu ausgewählt sind, einen kontinuierlichen Wellenlängenbereich abzudecken.

10. Halbleiterkomponente (1), umfassend eine Mehrzahl von Halbleiterstrukturen (10), welche dazu vorgesehen sind, eine elektromagnetische Strahlung (2) zu empfangen, **dadurch gekennzeichnet, dass** wenigstens die eine der Strukturen (10) eine Struktur nach einem der vorhergehenden Ansprüche ist.

11. Herstellungsverfahren für eine Struktur (10), welche dazu vorgesehen ist, eine elektromagnetische Strahlung (2) in einem ersten, als funktionell bezeichneten, Wellenlängenbereich zu empfangen, welcher um eine Wellenlänge λ₀ zentriert ist, **dadurch gekennzeichnet, dass** es die Schritte umfasst, bestehend aus:
- Bereitstellen eines Trägers (100), welcher eine erste und eine zweite Fläche aufweist,
- Bilden einer ersten Halbleiterschicht (121) von einem ersten Leitfähigkeitstyp, wobei wenigstens ein Abschnitt der ersten Halbleiterschicht (121) eine erste Halbleiterzone (11) bildet,
- Bilden einer Halbleitermesa (130) in Kontakt mit der ersten Halbleiterschicht (121), wobei die Mesa (130) einen zweiten Leitfähigkeitstyp aufweist, welcher dem ersten Leitfähigkeitstyp entgegengesetzt ist, und einen Abschnitt in Kontakt mit der ersten Halbleiterschicht (121) umfasst, dessen Konzentration an Majoritätsladungsträgern wenigstens zehnmal kleiner als die Konzentration an Majoritätsladungsträgern der ersten Halbleiterschicht (121) ist, wobei die Mesa (130) wenigstens eine Richtung, genannt einschließende, aufweist, entlang welcher die Mesa (130) eine mittlere Abmessung von λ₀/2n_{eff} aufweist, wobei n_{eff} der mittlere effektive Index der zweiten Zone ist, wobei die Mesa (130) wenigstens teilweise eine zweite Halbleiterzone (12) bildet,
- derartiges Anlagern einer Schicht aus einem Material, welches wenigstens teilweise in dem funktionellen Bereich reflektierend ist, dass eine als reflektierend bezeichnete Zone gebildet wird, wobei die reflektierende Zone (141) wenigstens einen Teil der Mesa (130) derart bedeckt, dass ein erster Hohlraum vom Fabry-Pérot-Typ gebildet wird, welcher eine mittlere Abmessung aufweist, welche im Wesentlichen gleich λ₀/2n_{eff} entlang der Einschlussrichtung ist,
wobei die elektromagnetische Strahlung in einem Medium mit optischem Index nᵢ, genannt Einfallsindex, empfangen wird, wobei das Verhältnis zwischen dem effektiven Index und dem Einfallsindex n_{eff}/nᵢ größer als 1 ist, vorzugsweise wesentlich größer als 1,5 und weiter vorzugsweise größer als 2.

12. Verfahren zum Herstellen einer Struktur (10), welche dazu vorgesehen ist, eine elektromagnetische Strahlung (2) in einem ersten, als funktionell bezeichneten, Wellenlängenbereich zu empfangen, welcher um eine Wellenlänge λ₀ herum zentriert ist, **dadurch gekennzeichnet, dass** es die Schritte umfasst, bestehend aus:
- Bereitstellen eines Trägers (100), welcher eine erste und eine zweite Fläche aufweist,
- Bilden einer ersten Halbleiterschicht (121) von einem ersten Leitfähigkeitstyp, wobei wenigstens ein Abschnitt der ersten Halbleiterschicht (121) eine erste Halbleiterzone (11) bildet,
- Bilden einer zweiten Halbleiterschicht (122) in Kontakt mit der ersten Halbleiterschicht (121), wobei die zweite Halbleiterschicht (122) von einem zweiten Leitfähigkeitstyp ist, welcher dem ersten Leitfähigkeitstyp entgegengesetzt ist, wobei wenigstens ein Teil der zweiten Halbleiterschicht (122), welcher in Kontakt mit der ersten Halbleiterschicht (121) ist, eine Konzentration an Majoritätsladungsträgern aufweist, welche wenigstens zehnmal kleiner als die Konzentration an Majoritätsladungsträgern der ersten Halbleiterschicht (121) ist,
- Bilden einer Halbleitermesa (130) in Kontakt mit dem Teil der zweiten Halbleiterschicht (122), wobei die Mesa (130) von dem zweiten Leitfähigkeitstyp ist und einen Teil in Kontakt mit dem Teil der zweiten Halbleiterschicht (121) umfasst, dessen Konzentration an Majoritätsladungsträgern wenigstens zehnmal kleiner als die Konzentration an Majoritätsladungsträgern der ersten Halbleiterschicht (121) ist, wobei die Mesa wenigstens eine Richtung, genannt einschließende, aufweist, entlang welcher die Mesa (130) eine mittlere Abmessung von λ₀/2n_{eff} aufweist, wobei n_{eff} der mittlere effektive Index der zweiten Zone ist, wobei die Mesa (130) mit der zweiten Halbleiterschicht (122) wenigstens teilweise eine zweite Halbleiterzone (12) bildet und der Teil der Mesa (130) mit dem Teil der zweiten Halbleiterschicht (122) einen Abschnitt der zweiten Zone bildet,
- Anlagern einer Schicht aus einem Material, welches wenigstens teilweise in dem funktionellen Bereich reflektierend ist, wobei die Schicht wenigstens einen Teil der Mesa (130) derart bedeckt, dass ein erster Hohlraum vom Fabry-Pérot-Typ gebildet wird, welcher eine mittlere Abmessung aufweist, welche im Wesentlichen gleich λ₀/2n_{eff} entlang der Einschlussrichtung ist,
wobei die Struktur dazu eingerichtet ist, dass die elektromagnetische Strahlung in einem Medium mit optischem Index nᵢ, genannt Einfallsindex, empfangen wird, wobei das Verhältnis zwischen dem effektiven Index und dem Einfallsindex n_{eff}/nᵢ größer als 1 ist, vorzugsweise wesentlich größer als 1,5 und weiter vorzugsweise größer als 2.

13. Verfahren zum Herstellen nach dem vorhergehenden Anspruch, wobei vor dem Schritt des Bildens der zweiten Halbleiterschicht (122) ein Schritt eines Bildens einer dritten Halbleiterschicht (123) vom ersten Leitfähigkeitstyp in Kontakt mit der ersten Halbleiterschicht (121) vorgesehen ist, wobei die erste Schicht und die dritte Halbleiterschicht (123) eine Konzentration an Unreinheiten vom Typ eines Donators von Majoritätsladungsträgern des zweiten Leitfähigkeitstyps umfasst, welche wenigstens zehnmal kleiner als die Konzentration an Majoritätsladungsträgern der ersten und dritten Halbleiterschichten (121, 123) ist, wobei die Schritte des Bildens der Mesa (130) und der zweiten Halbleiterschicht (122) durch Ätzen der dritten Halbleiterschicht (123) und eines Teils der ersten Halbleiterschicht (121) erhalten werden, wobei dieser Schritt eines Ätzens dazu eingerichtet ist, die Majoritätsladungsträger des ersten Leitfähigkeitstyps zu hemmen.

## Claims

1. A semiconducting structure (10) intended to receive electromagnetic radiation (2) in a first range of wavelengths, a so-called operating range, which is centered around a wavelengths λ₀, including:
- a first semiconducting area (11) of a first type of conductivity,
- a second semiconducting area (12) of a second type of conductivity opposed to the first type of conductivity, the second semiconducting area (12) being in contact with the first semiconducting area (11) so as to form a semiconducting junction,
the structure (10) **being characterized in that** the second semiconducting area (12) has a portion for which the concentration of majority carries is at least ten times less than the concentration of majority carriers of the first semiconducting area (11), said portion being in contact with the first semiconducting area (12),
**and in that** said portion of the second semiconducting area (12) is essentially made in a first cavity adapted for focusing in the first cavity at least a part of the received electromagnetic radiation (2),
wherein the first cavity is a cavity of the Fabry-Perot type, the first cavity having along at least one confinement direction an average dimension substantially equal to λ₀/2n_{eff} with n_{eff} being the average effective index in the second area, and
wherein the electromagnetic radiation is received in a medium of optical index nᵢ, a so-called incident index, the ratio between the effective index and the incident index n_{eff}/nᵢ being greater than 1, preferentially substantially greater that 1.5 and even more preferentially greater than 2.

2. The structure (10) according claim 1, wherein the dimension of the first cavity along the confinement direction is a variable dimension, said dimension preferentially decreasing along the direction directed from the first semiconducting area (11) to the second semiconducting area (12).

3. The structure (10) according to the preceding claim, wherein the first and the second semiconducting areas (11, 12) have band gap widths of different energies, the first semiconducting area (11) having a greater average band gap energy width than that of a radiation for which the wavelength is comprised in the operating range.

4. The structure (10) according to the preceding claim, wherein the second semiconducting area (12) includes, in addition to said portion, a part not made in the cavity and having a greater average band gap width energy than that of electromagnetic radiation for which the wavelength is comprised in the operating range, and said portion having an average band gap width energy of less than that of electromagnetic radiation for which the wavelength is comprised in the first operating range.

5. The structure (10) according to one of the preceding claims, wherein the first and the second semiconducting areas (11, 12) are made in semiconducting materials essentially consisting of at least three same elements for which the concentration of at least one of these elements allows variation of the band gap width, said elements being preferentially cadmium (Cd), mercury (Hg) and tellurium (Te).

6. The structure (10) according any one of the preceding claims, wherein provision is made for:
- a support (100), transparent in the operating range, the substrate including a first and a second face,
- a first semiconducting layer (121) of the first type of conductivity extending along the first face, in contact with this same first face, a portion of said first semiconducting layer (121) forming the first semiconducting area,
- a semiconducting mesa (130) with direct contact, or via a second semiconducting layer of the second type of conductivity, with the face of the first semiconducting layer (121) which is opposite to the first face, said mesa (130) having the second type of conductivity and a concentration of majority carriers which is at least ten times less than that of the first semiconducting layer (121), said mesa (130) at least partly forming the second semiconducting area (12), the mesa (130) having at least one direction, the confinement direction, along which the mesa (130) has an average dimension of λ₀/2n_{eff} , the part of the mesa at least partly forming the portion of the second semiconducting area,
- a so-called reflective area (141) of at least one material partly reflective in the operating range, said reflective area (141) covering at least one part of the mesa (130) so as to form the first cavity of the Fabry-Perot type which has an average dimension substantially equal to λ₀/2n_{eff} along the confinement direction.

7. The structure (10) according to one of the preceding claims, wherein, at least a third and a fourth semiconducting area are further provided, respectively having the first and the second type of conductivity, the third and the fourth semiconducting area being in contact with each other so as to form a semiconducting junction, the fourth semiconducting area has a second portion for which the concentration of majority carriers is at least ten times less than the concentration of majority carriers of the third semiconducting area, said second portion being the portion of the fourth semiconducting area which is in contact with the third semiconducting area, the fourth semiconducting area is essentially made in a second cavity, said second cavity being adapted for concentrating in the second cavity, a portion of electromagnetic radiation (2) which is received by the structure (10) and for which the wavelength is comprised in a range of wavelengths, a so-called second operating range.

8. The structure (10) according to the preceding claim, wherein the second operating range is substantially identical with the first operating range.

9. The structure (10) according to claim 7, wherein the second operating range is different from the first operating range, the first and the second operating range being preferentially selected so as to cover a continuous range of wavelengths.

10. A semiconductor component (1) including a plurality of semiconducting structures (10) intended to receive electromagnetic radiation (2), **characterized in that** at least one of the structures (10) is a structure according to any of the preceding claims.

11. A method for manufacturing a structure (10) intended to receive electromagnetic radiation (2) in a first range of wavelength, a so-called operating range, which is centered around a wavelength λ₀, **characterized in that** it includes the steps :
- providing a support (100) having a first and a second face,
- forming a first semiconducting layer (121) of a first type of conductivity, at least one portion of said first semiconducting layer (121) forming a first semiconducting area (11),
- forming a semiconducting mesa (130) in contact with the first semiconducting layer (121), said mesa (130) being of a second type of conductivity opposed to the first type of conductivity and including a portion, in contact with the first semiconducting layer (121), for which the concentration of majority carriers is at least ten times less than the concentration of majority carriers of the first semiconducting layer (121), the mesa (130) having at least one direction, a so-called confinement direction, along which the mesa (130) has an average dimension of λ₀/2n_{eff} with n_{eff} being the average effective index in the second area, the mesa (130) at least partly forming with a second semiconducting area (12),
- depositing a layer of a material at least partly reflective in the operating range so as to form a so-called reflective area, the reflective area (141) covering at least one portion of the mesa (130) so as to form a first cavity of the Fabry-Perot type which has an average dimension substantially equal to λ₀/2n_{eff} along the confinement direction,
wherein the electromagnetic radiation is received in a medium of optical index ni, a so-called incident index, the ratio between the effective index and the incident index neff/ni being greater than 1, preferentially substantially greater that 1.5 and even more preferentially greater than 2.

12. A method for manufacturing a structure (10) intended for receiving electromagnetic radiation (2) in a first range of wavelengths, a so-called operating range, which is centered around a wavelength λ₀, **characterized in that** it includes the steps:
- providing a support (100) having a first and a second face,
- forming a first semiconducting layer (121) of a first type of conductivity, at least one portion of said first semiconducting layer (121) forming a first semiconducting area (11),
- forming a second semiconducting layer (122) in contact with the first semiconducting layer (121), said second semiconducting layer (122) being of a second type of conductivity which is opposed to the first type of conductivity, at least a part of the second semiconducting layer (122), which is in contact with the first semiconducting layer (121), having a concentration of majority carriers which is at least ten times less than the concentration of majority carriers of the first semiconducting layer (121),
- forming a semiconducting mesa (130) in contact with the portion of the second semiconducting layer (122), said mesa (130) being of the second type of conductivity and comprising a least a part, in contact with the part of the second semiconducting layer (122), for which the concentration of majority carriers is at least ten times less than the concentration of majority carriers of the first semiconducting layer (121), the mesa having at least one direction, a so-called confinement direction, along which the mesa (130) has an average dimension of λ₀/2n_{eff} with n_{eff} being the average effective index in the second area, the mesa (130) at least partly forming with the second semiconducting layer (122), a second semiconducting area (12) and the part of the mesa (130) forming with the part of the second semiconducting layer (122), a portion of the second area,
- depositing a layer of a material at least partly reflective in the operating range, said layer covering at least one portion of the mesa (130) so as to form a first cavity of the Fabry-Perot type which has an average dimension substantially equal to λ₀/2n_{eff} along the confinement direction,
wherein the electromagnetic radiation is received in a medium of optical index ni, a so-called incident index, the ratio between the effective index and the incident index neff/ni being greater than 1, preferentially substantially greater that 1.5 and even more preferentially greater than 2.

13. The manufacturing method according to preceding claim, wherein, before the step for forming the second semiconducting layer (122), a step is provided for forming a third semiconducting layer (123), of the first type of conductivity in contact with the first semiconducting layer (121), the first layer and the third semiconducting layer (123) including a concentration of impurities, of the majority carrier donor type of the second type of conductivity, which is at least ten times less than the concentration of majority carriers of said first and third semiconducting layers (121, 123), the steps for forming the mesa (130) and the second semiconducting layer (122) being obtained by etching the third conductive layer (123) and a portion of first semiconducting layer (121), this etching step being adapted in order to inhibit the majority carriers of the first type of conductivity.
